(19) Europäisches Patentamt
European Patent Office
Office européen des brevets

(11) EP 4 518 630 A1

(12) EUROPEAN PATENT APPLICATION

(43) Date of publication:
05.03.2025 Bulletin 2025/10

(21) Application number: 24197362.7

(22) Date of filing: 29.08.2024

(51) International Patent Classification (IPC):
H10K 59/131 (2023.01)     B41J 2/45 (2006.01)
G03G 15/04 (2006.01)      H10K 59/80 (2023.01)
H10K 59/82 (2023.01)      H10K 59/90 (2023.01)
H10K 71/00 (2023.01)

(52) Cooperative Patent Classification (CPC):
H10K 59/80521; B41J 2/45; G03G 15/04054;
H10K 59/131; H10K 59/82; H10K 59/90;
H10K 71/60

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 30.08.2023 JP 2023139407
10.06.2024 JP 2024093957

(71) Applicant: CANON KABUSHIKI KAISHA
Tokyo 146-8501 (JP)

(72) Inventors:
• SUMIDA, Takayuki
  Tokyo, 146-8501 (JP)
• MIURA, Seishi
  Tokyo, 146-8501 (JP)
• KODAMA, Hideki
  Tokyo, 146-8501 (JP)
• ITABASHI, Masumi
  Tokyo, 146-8501 (JP)

(74) Representative: Canon Europe Limited
European Intellectual Property Group
4 Roundwood Avenue
Stockley Park
Uxbridge UB11 1AF (GB)

(54) OLED CHIP, EXPOSURE HEAD, IMAGE FORMING APPARATUS, AND METHOD OF MANUFACTURING OLED CHIP

(57) An aspect of the present disclosure relates to an OLED chip (53) that includes: a light emitting region (60) where a plurality of light emitting devices (69) is two-dimensionally arranged on a surface of a substrate (61); and a contact region (64a) disposed outside the light emitting region (60). Each of the plurality of light emitting devices (69) includes a second electrode (67) which is continuous over the plurality of light emitting devices (69), the light emitting region (60) has a long side extending in a first direction (X) and a short side extending in a second direction (Y') intersecting the first direction (X), and an end of the second electrode (67) in the first direction (X) has a portion non-parallel to a third direction (Y) perpendicular to the first direction (X).

FIG. 1A

EP 4 518 630 A1

**Description**

TECHNICAL FIELD

The present disclosure relates to an OLED chip, an exposure head, an image forming apparatus, and a method of manufacturing an OLED chip.

BACKGROUND

Description of the related art

The technique described in Japanese Patent Laid-Open No. 2006-236727 has been known as a technique related to an exposure head used for an electrophotographic image forming apparatus.

The exposure head described in Japanese Patent Laid-Open No. 2006-236727 includes a substrate upon which a plurality of light emitting devices is arranged in the axial direction of a photoconductor drum, and a lens that collects the light emitted from the plurality of light emitting devices. In the exposure head, the light emitted from the plurality of light emitting devices is collected through the lens to expose the photoconductor drum.

Thus, the exposure head described in Japanese Patent Laid-Open No. 2006-236727 is disposed close to the photoconductor drum along with a developing device that develops, with toner, a latent image formed on the photoconductor drum. Therefore, the exposure head is disposed close to the developing device. The exposure head includes an organic light emitting diode (OLED) as a light emitting device.

In the exposure head, ghost spots may occur due to stray light incident on the photoconductor drum. If the ratio of stray light versus normal light for exposure increases, then the print quality deteriorates.

A known organic light emitting device structure (e.g., such as an OLED) includes a light emitting-side electrode among a plurality of electrodes disposed with an organic light emitting layer interposed therebetween.

The configuration described in Japanese Patent Laid-Open No. 2006-236727 includes an organic light emitting device disposed on a glass substrate and a second electrode disposed on the opposite side of a projection surface of outgoing light of the organic light emitting device, that is, the photoconductor drum.

SUMMARY

In a known organic light emitting device structure, the light emitted from the organic light emitting device may become unintended stray light due to scattering of the emitted light. The emitted light may be scattered either within a light emitting substrate of the device, in the housing of the exposure head in which the organic light emitting device is installed, or on the photoconductor drum surface. The resulting stray light may be reflected by an electrode made of the high reflectance metal. Therefore, a ghost spot may occur on the photoconductor drum due to stray light which has passed through a lens array of the device. In the configuration described in Japanese Patent Laid-Open No. 2006-236727, the second electrode is provided with a stray light reflection prevention unit. In particular, a roughness process is carried out on the second electrode of the organic light emitting device, and installation of an antireflection layer between the organic light emitting layer and the second electrode layer. Thus, the emission characteristics of the organic light emitting device itself may be lost.

An aspect of the present disclosure provides an OLED chip with a reduced ratio of stray light to normal light from the light emitting device without impairing the emission characteristics of the light emitting device, and a method of manufacturing the OLED chip.

The present disclosure in its first aspect provides an OLED chip comprising: a light emitting region (e.g., of the OLED chip) where a plurality of light emitting devices is two-dimensionally arranged on a surface of a substrate (e.g., a major surface of the substrate); and a contact region disposed outside the light emitting region, wherein each of the plurality of light emitting devices includes a first electrode, an organic layer, and a second electrode on a light emitting side, the second electrode is a common electrode of the plurality of light emitting devices, in plan view to the surface, the light emitting region has a long side extending in a first direction and a short side extending in a second direction intersecting the first direction, and in the plan view, an end of the second electrode in the first direction has a portion non-parallel to a third direction perpendicular to the first direction.

The present disclosure in its second aspect provides an exposure head comprising: a plurality of OLED chips disposed on a head substrate, wherein each of the plurality of OLED chips has a side parallel to a longitudinal direction and a side parallel to a transverse direction, and at least one of the plurality of OLED chips is an OLED (e.g., an OLED chip according to the first aspect).

The present disclosure in its third aspect provides an image forming apparatus comprising: a photoconductor drum; an exposure head that is disposed to be opposed to the photoconductor drum and is arranged to expose the photoconductor drum to form a latent image on the photoconductor drum; and a developing unit that is arranged to develop, with toner, the latent image formed on the photoconductor drum, wherein the exposure head is the exposure head according the first and/or second aspects.

The present disclosure in its fourth aspect provides a method of manufacturing an OLED chip, the method comprising: arranging a vapor deposition mask having a plurality of openings to be opposed to a substrate in which a first electrode and an organic layer are disposed; positioning the substrate with respect to the vapor deposition mask; and forming a second electrode by depositing a vapor deposition material on the substrate through the openings of the vapor deposition mask, wherein the openings of the vapor deposition mask have a long side extending in a first direction, a short side extending in a second direction intersecting the first direction, and a portion at an end in the first direction, the portion being non-parallel to a third direction perpendicular to the first direction.

Optional features will now be set out. These are applicable singly or in any combination with any aspect of the disclosure.

Optionally, in the plan view, a length of the long side of the light emitting region is greater than or equal to five times a length of the short side.

Optionally, in the plan view, the end of the second electrode has a curve.

Optionally, in the plan view, a length in the third direction of the portion non-parallel to the third direction is longer than 1/3 a distance from an end of the second electrode in the third direction to a portion at which the second electrode is in contact with a wire (e.g., wiring).

Optionally, a color filter is disposed on the contact region, the color filter includes the contact region in the plan view, and an opening is provided at a position overlapping the light emitting region.

Optionally, the OLED chip further comprises: a first color filter overlapping the contact region in the plan view; and a second color filter overlapping the light emitting region in the plan view, wherein a color of light transmitted through the second color filter is different from a color of light transmitted through the first color filter.

Optionally, the first color filter has a lower transmittance than the second color filter for light from the plurality of light emitting devices.

Optionally, the substrate is a silicon substrate.

Optionally, the substrate has a thickness of 200 $\mu$m to 700 $\mu$m.

Optionally, the substrate has a thickness of 200 $\mu$m to 408 $\mu$m.

Optionally, the substrate has a thickness of 378 $\mu$m to 408 $\mu$m.

Optionally, of the plurality of OLED chips, two adjacent OLED chips in the longitudinal direction are disposed with a deviation in the transverse direction.

Optionally, the plurality of OLED chips is disposed so that the second electrode is opposed to the lens array.

Optionally, in plan view to a surface of the substrate, a length of a long side of a light emitting region of an OLED chip to be manufactured is greater than or equal to five times a length of a short side of the light emitting region.

Further features of the present disclosure will become apparent from the following description of example embodiments with reference to the attached drawings.

BRIEF DESCRIPTION OF THE DRAWINGS

Fig. 1A is a schematic view of an example of part of an OLED chip in plan view, Fig. 1B is a sectional view taken along line IB-IB of the OLED chip of Fig. 1A, Fig. 1C is an enlarged view of region IC of the OLED chip of Fig. 1A, the region IC being surrounded by a dashed-dotted line, Fig. 1D is a view illustrating an example of a light emitting region of the OLED chip of Fig. 1A, and Fig. 1E is a sectional view taken along line IE-IE of the OLED chip.

Fig. 2 is an enlarged view of the OLED chip shown in Fig. 1A, for explaining the shape of a second electrode.

Figs. 3A and 3B are schematic views of an example of part of the OLED chip in plan view.

Figs. 4A and 4B are schematic views of an example of part of the OLED chip in plan view.

Fig. 5A is a schematic view of an example of part of the OLED chip having a color filter in plan view, and Fig. 5B is a sectional view taken along line VB-VB of the OLED chip of Fig. 5A.

Fig. 6A is a schematic view of an example of part of the OLED chip having a color filter in plan view, and Fig. 6B is a sectional view taken along line VIB-VIB of the OLED chip of Fig. 6A.

Fig. 7 is a sectional view illustrating an example of an exposure head.

Figs. 8A to 8E are each a schematic view for explaining a head substrate and a lens array in the exposure head.

Figs. 9A to 9C are schematic views for explaining a method of manufacturing part of an OLED chip.

Fig. 10 is a perspective view of an image forming apparatus.

Fig. 11 is a schematic sectional view of the image forming apparatus in Fig. 10.

Fig. 12 is a schematic view of an example of part of an OLED chip.

DESCRIPTION OF THE EMBODIMENTS

Embodiments for implementing the present disclosure will be described below with reference to the drawings. Note that the dimensions, materials, shapes, and relative arrangement of the components described below are not intended to limit the scope of the present disclosure unless otherwise specifically described.

First Example Embodiment

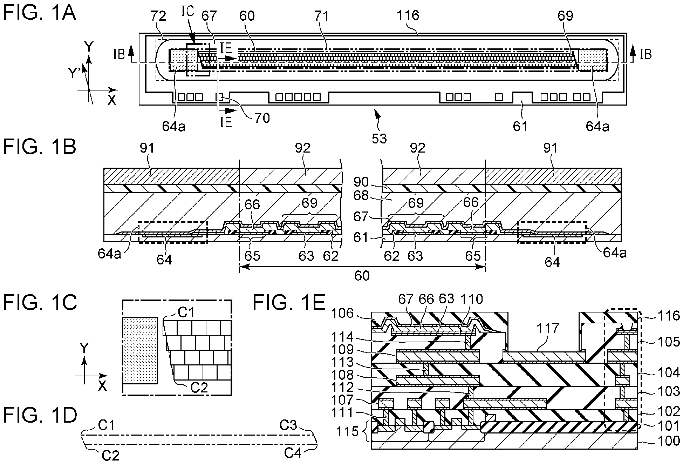

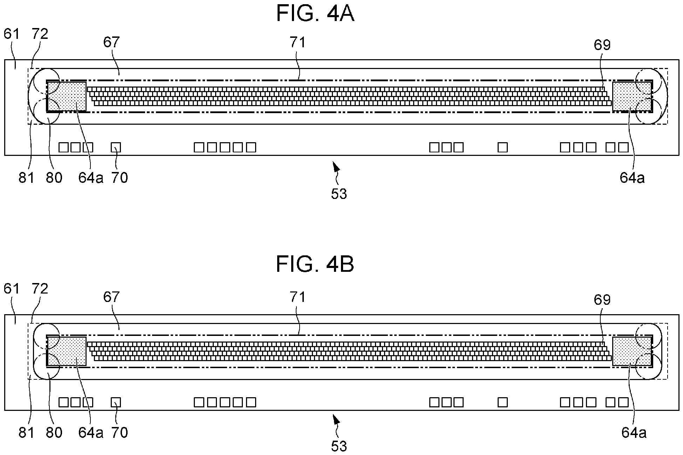

An example of an OLED chip of the present embodiment will be described with reference to Figs. 1A-1E to Figs. 4A and 4B. A light emitting device 69 in an OLED chip 53 includes, on a substrate 61, a first electrode 63, a second electrode 67, and an organic layer 66 disposed between the first electrode and the second electrode. A protective layer, and a color filter may be provided on the second electrode 67. When a color filter is provided, a planarizing layer may be provided between the protective layer and the color filter. The planarizing layer may be made of acrylic resin.

A specific configuration example of the OLED chip will be described with reference to the drawings. Fig. 1A is a schematic plan view illustrating an example of part of the OLED chip 53 for which a light emitting device of the present embodiment is used. Fig. 1B is a schematic view of a section taken along line IB-IB in Fig. 1A. Plan view refers to a plan view in a direction perpendicular to a plane (direction normal to the plane).

As illustrated in Fig. 1A, the OLED chip 53 of the present embodiment includes: a light emitting region 60 where a plurality of light emitting devices 69 is two-dimensionally arranged on the major surface of the substrate 61; and contact regions 64a provided outside the light emitting region 60.

As illustrated in Fig. 1B, the plurality of light emitting devices 69 includes: the first electrode 63 disposed on the major surface of the substrate 61; the organic layer 66 disposed on the first electrode 63 and including at least a light emitting layer; and the second electrode 67 (the upper electrode) disposed on the light emitting side. The second electrode 67 is continuous over the plurality of light emitting devices 69. In plan view to the major surface, the light emitting region 60 has a long side extending in a first direction X, and a short side extending in a second direction Y' intersecting the first direction, herein an example of a rectangle is shown. In the plan view, the end of the second electrode 67 in the first direction X has a portion non-parallel to a third direction Y perpendicular to the first direction X. The details will be described below.

The OLED chip 53 has: an insulating layer 62 that covers the end of the first electrode 63, the insulating layer 62 having an opening 65 over the first electrode 63 and functioning as a bank; and a protective layer 68 disposed over the second electrode 67. In addition, the OLED chip 53 has wiring 64 disposed on the contact regions 64a in order to apply a voltage to the second electrode 67. Also, the OLED chip 53 has a pad 70 to input a control signal from an image forming apparatus body to each OLED chip 53. In the OLED chip 53, a moisture-resistant ring 116 is disposed surrounding the light emitting region 60, the contact regions 64a, and the pad 70. Entry of moisture into the light emitting device can be inhibited by the moisture-resistant ring 116.

Note that in the present specification, the light emitting region 60 of the OLED chip refers to the entirety of device light emitting regions of the plurality of light emitting devices disposed on the substrate of the OLED chip in the plan view. Thus, the shape of the light emitting region 60 of the OLED chip is the outer edge shape when the entirety of device light emitting regions of the plurality of light emitting devices is regarded as one light emitting region, and may include a non-emission region such as a bank region.

Specifically, the outer edge shape of the light emitting region 60 is the region obtained by connecting the ends of the openings 65 of the insulating layers 62 of the plurality of outermost light emitting devices. Thus, as illustrated in Fig. 1B, in the section taken along line IB-IB of the OLED chip, the light emitting region 60 is the region partitioned by a dashed-dotted line.

Referring to Fig. 1C, the outer edge shape of the light emitting region will be described more specifically. Fig. 1C illustrates an enlarged view of region IC of the OLED chip of Fig. 1A, the region IC being surrounded by a dashed-dotted line. Here, of the four light emitting devices located outermost in the first direction X, two light emitting devices located outermost in the second direction Y have corner C1 and corner C2 located outermost of the openings 65 of the insulating layers 62 of the two light emitting devices. Similarly, of the four light emitting devices located outermost on the opposite side in the first direction X, two light emitting devices located outermost in the second direction Y have corner C3 and corner C4 located outermost of the openings 65 of the insulating layers 62 of the two light emitting devices.

At this point, as illustrated in Fig. 1D, the shape formed by the line segments connecting corner C1, corner C2, corner C3 and corner C4 is the outer edge shape of the light emitting region 60. For example, in Figs. 1A to 1E, the light emitting region 60 is a parallelogram having long sides extending in the first direction X, and short sides extending in the second direction Y' intersecting the first direction X. Note that corner C1, corner C2, corner C3, and corner C4 may be rounded due to processing accuracy and alignment accuracy in the manufacturing process. Even in this situation, the outer edge shape can be identified by the tip of each corner, which is the point where two line segments forming the corner intersect each other.

Here, the device light emitting regions of the plurality of light emitting devices may have a disconnected portion or a gap along the long side and the short side of the light emitting region 60; however, as described above, the outer edge of the light emitting region 60 of the OLED chip is defined by an approximate line for the outer edge of these device light emitting regions. For example, the first direction X, and the second direction Y' are directions parallel to the approximate straight lines for the outermost light emitting regions of the device light emitting regions of the plurality of light emitting devices.

The device light emitting region that is the light emitting region of each light emitting device refers to the portion where the first electrode 63, the organic layer 66, and the second electrode 67 are laminated in the opening 65 of the insulating layer 62. A non-light emission region indicates the region other than the light emitting region.

In plan view, the length of the long side of the light emitting region 60 of the present embodiment is greater than or equal to five times the length of the short side. In the OLED chip 53, the area occupied by the light emitting region 60 is the largest. Therefore, the length of the long side of the OLED chip 53 is also greater than or equal to five times the short side of the OLED chip 53.

Arrangement and Shape of Second Electrode

Referring to Figs. 1A to 1E, the shape of the second electrode 67 of the OLED chip 53 will be described. In order to reduce stray light in the OLED chip 53, the area of the second electrode 67, causing unintended stray light by reflection may be decreased as much as possible. However, the second electrode 67 has a certain area necessary for the light emitting devices 69 to achieve the original function. Therefore, the area of the second electrode 67 should be decreased as much as possible without impairing the emission characteristics of the light emitting devices 69.

In the present embodiment, as an aspect, an example will be described in which contact region 64a is located at longitudinal both ends of the light emitting region 60 where the light emitting devices 69 are two-dimensionally arranged in the longitudinal direction and transverse direction. However, each contact region 64a may be at any location on the substrate 61.

Since the second electrode 67 is extended to the contact regions 64a and deposited, when the contact regions 64a are disposed away from the light emitting region 60, the second electrode area increases. Thus, the contact regions 64a may be located close to the light emitting region 60. From the viewpoint of electrical resistance, the contact regions 64a may be located close to the light emitting region 60.

The second electrode of the present embodiment is removed in part at the end in the first direction X, and as a consequence, the end has a portion non-parallel to the third direction Y. In this manner, a portion non-parallel (a notch portion is provided) to the third direction Y is provided, thus the area of the second electrode can be reduced, as compared to when a notch portion is not provided.

This will be described in detail. When the contact regions 64a are outside the light emitting region 60, theoretically, the area of the second electrode 67 can be made smallest by depositing the second electrode 67 along the outermost periphery of the light emitting region 60 and the contact regions 64a. For example, when the structure of Fig. 1A is adopted, the area of the second electrode 67 can be made smallest by setting the deposition region of the second electrode 67 to a closed region 71 including the plurality of light emitting devices 69, shown by a two-dot-dash line connecting the four corners of the contact region 64a.

However, for example, when the second electrode 67 is formed via an opening of a vapor deposition mask by a vacuum evaporation method, a gap is provided between the substrate where the second electrode is formed by vapor deposition, and the vapor deposition mask, and a film formed by vapor deposition has a portion of vapor deposition blur. The portion of vapor deposition blur has a less film thickness, thus the electrical resistance tends to be higher, which is disadvantageous. Thus, the shape of the second electrode 67 needs an isotropic width of margin (M) corresponding to predetermined alignment accuracy of the vapor deposition device to be used. Therefore, a region 72 including the region 71, shown by a dashed line needs to be the deposition region of the second electrode 67, and the area of the second electrode 67 which contributes to reflection of unintended light is made greater than the region 71.

Fig. 1E illustrates a sectional view taken along line IE-IE of the OLED chip of Fig. 1A. In the substrate 100, a transistor 115 to drive light emitting devices, and an insulator 101 are disposed. Over the transistor 115 and the insulator 101, an insulating layer 102, a plug 111 installed in the insulating layer 102, a conductive layer 107, an insulating layer 103, and a plug 112 installed in the insulating layer 103 are disposed in that order from the substrate 100.

In addition, over the insulating layer 103, a conductive layer 108, an insulating layer 104, a plug 113 installed in the insulating layer 104, a conductive layer 109, a conductive layer 117 functioning as a pad electrode, an insulating layer 105, and a plug 114 installed in the insulating layer 105 are disposed in that order from the substrate. On the insulating layer 105, a conductive layer 110 functioning as the first electrode 63 of the light emitting device is disposed, and an insulating layer 106 is disposed to cover the insulating layer 105, the conductive layer 110, and the conductive layer 117.

The insulating layer 101 may be e.g., a silicon oxide film such as LOCOS. The insulating layer 102, the insulating layer 103, the insulating layer 104, and the insulating layer 105 can be formed by e.g., a film having at least one of silicon oxide, silicon oxynitride, silicon nitride oxide, silicon nitride, and aluminum oxide, or by lamination of these. Here, the insulating layer 102, the insulating layer 103, the insulating layer 104, and the insulating layer 105 show an example of a silicon oxide film.

The insulating layer 106 may be a film with low moisture permeability. The insulating layer 106 may be e.g., a silicon nitride film, an aluminum oxide film, or lamination of these films.

The conductive layer 107, the conductive layer 108, and the conductive layer 109 may be e.g., a layer of metal such as copper, aluminum, or cobalt, and in addition, may be laminated layers including a titanium nitride layer, and functions as a wire, for example. As the conductive layer 110, for example, aluminum, an aluminum alloy, laminated layers of aluminum or an aluminum alloy and titanium nitride may be used. The first electrode 63 will be described in detail later.

The moisture-resistant ring 116 includes: a conductive layer such as the plug 111, the conductive layer 107, the plug 112, the conductive layer 108, the plug 113, the conductive layer 109, the plug 114; and the insulating layer 106. Surrounding the light emitting region with the moisture-resistant ring 116 including these layers with low moisture permeability can inhibit permeation of moisture into the light emitting devices. The moisture-resistant ring is not limited to this, and the portion of the conductive layer may be replaced by an insulating layer, such as a nitride film, with low moisture permeability, or may be a film including silicon oxide in part. Even with this configuration, moisture permeability can be inhibited by other portions, thus the ring essentially functions as a moisture-resistant ring.

Therefore, when the moisture-resistant ring 116 of the present embodiment essentially functions as a moisture-resistant ring, a configuration may be adopted in which part of the layers does not inhibit moisture permeability like this.

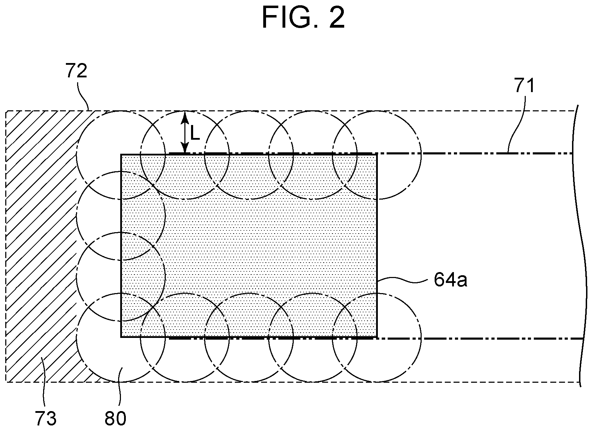

Fig. 2 is an enlarged view of the periphery of the contact region 64a. A circle 80 is a virtual circle for illustration shown by a dashed-dotted line, and has the center at a corner of the contact region 64a with a radius of a width of margin (M) corresponding to alignment accuracy.

As illustrated in Fig. 2, part of the second electrode 67 is removed outside the circle 80 (a notch portion 81 is provided), thus the second electrode 67 has a shape such that the end thereof in the first direction X has a portion non-parallel to the third direction Y. Thus, the area of the second electrode 67 to be formed can be made smaller than when the second electrode 67 is deposited on the region 72 having a long side as a tangent line to the circle 80, and a short side extending in the third direction.

By adopting such a configuration, even when alignment deviates at most, the second electrode 67 can cover the contact region 64a in any region, and the area of the second electrode 67 which contributes to reflection of unintended light can be reduced with sufficient electrical contact. In the present embodiment, an example with a rectangular contact region 64a has been shown, thus the center of the circle 80 is at a corner of the contact region 64a; however, the center of the circle 80 is not limited to this.

Even when the contact region 64a is not rectangular, in the locus of arc such that the center of the circle 80 moves along the line of the outermost periphery of the contact region 64a, the points farthest away from the light emitting region 60 may be connected and drawn. In the region 73 outward of thus derived shape, the area of the second electrode 67 can be reduced by removing (providing the notch portion 81) at least part of the second electrode 67 without impairing the emission characteristics of the light emitting devices 69.

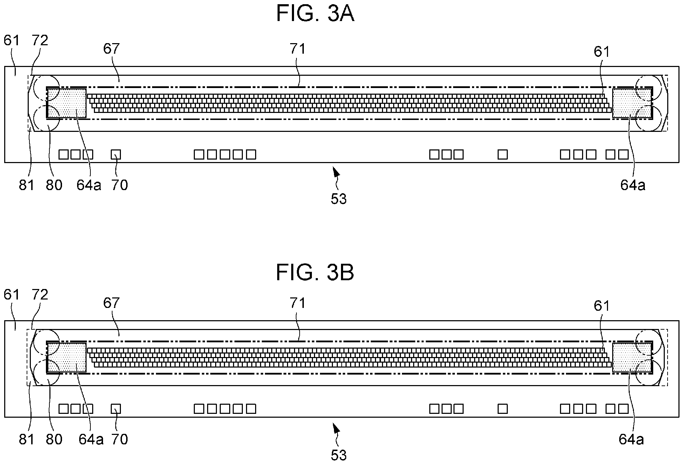

As in Fig. 3A, the shape may be obtained by cutting off the corners where the line which passes through the outermost of the light emitting region 60 and the contact regions 64a and is parallel to the long side of the light emitting region 60 intersects the line which passes through the outermost of the light emitting region 60 and the contact regions 64a and is parallel to the short side of the light emitting region 60. As in Fig. 3B, in the configuration of Fig. 3A, the shape may be obtained by shifting the sides of the second electrode 67 parallel to the third direction Y toward the light emitting region 60 in the first direction, X-direction.

As illustrated in Fig. 4A, the end of the second electrode 67 in the first direction may be a shape having a curvature. For example, the end of the second electrode 67 in the first direction has a curve, specifically, has a shape such that a curve having a center of curvature in the light emitting region 60 is continuous. Also, in this case, the area of the second electrode 67 can be further reduced with the second electrode 67 covering the wiring 64. As in Fig. 4B, only the corners of the second electrode 67 are curved with a curvature, and central portions in the third direction Y (the direction perpendicular to the long side of the light emitting region) may be linear.

At the end of the second electrode 67 in the first direction, the length in the third direction of the portion non-parallel to the third direction Y may be longer than 1/3 the distance L (Fig. 2) from the end of the second electrode 67 in the third direction to the portion at which the second electrode 67 is in contact with the wiring 64. Furthermore, at the end of the second electrode 67 in the first direction, the length in the third direction of the portion non-parallel to the third direction Y may be longer than half the distance L from the end of the second electrode 67 in the third direction to the portion at which the second electrode 67 is in contact with the wiring 64. Fig. 2 illustrates an example in which the length in the third direction of the portion non-parallel to the third direction Y is approximately equal to the distance L from the end of the second electrode 67 in the third direction to the portion at which the second electrode 67 is in contact with the wiring 64.

At the time of film deposition by a vacuum evaporation method, the shape of the second electrode 67 may vary depending on the distance between a vapor deposition source and the substrate, the taper angle in a thickness direction of an opening of a vapor deposition mask, and whether the OLED chip is deposited near the center of the substrate or on the outer periphery. However, in plan view to the major surface of the substrate 61, the end of the second electrode 67 in the first direction X has a portion non-parallel to the third direction Y perpendicular to the first direction X, thus the area of the second electrode 67 can be reduced without impairing the emission characteristics of the light emitting devices 69. Therefore, reflection of unintended light due to the second electrode 67 can be reduced without impairing the emission characteristics of the light emitting devices 69.

Since the notch portion is provided, not only the area of the second electrode can be reduced, but also the perimeter of the second electrode can be reduced. It is known that an organic EL device as an example of the light emitting device of the present embodiment deteriorates due to moisture in the atmosphere. One of entry points of moisture to the organic EL device is the peripheral portion of the second electrode 67. Thus, reduction in the perimeter of the second electrode 67 can inhibit permeation of moisture into the light emitting device.

Substrate

The substrate 61 may be made of a material that can support the first electrode 63, the organic layer 66, and the second electrode 67. Although illustration is omitted in Fig. 1B, an active element such as a transistor may be disposed on the substrate 61. In addition, an interlayer insulating layer and/or a wiring layer may be disposed between the substrate 61 and the first electrode 63 as a single layer or multiple layers.

E.g., glass, plastic, or silicon may be used for the substrate 61. In the present embodiment, an example is shown in which a silicon substrate is used. The thermal conductivity of a glass substrate is approximately 0.55 to 1.1 W/m·K, whereas the thermal conductivity of a silicon substrate is approximately 162 W/m·K, thus a silicon substrate has an extremely high thermal conductivity.

It is known that an organic light emitting device dissipates heat according to the length of light emission time and the magnitude of the amount of light emission. Therefore, the heat generated at the time of driving the light emitting devices 69 is advantageously dissipated efficiently.

Even when the light emitting devices 69 formed on the substrate 61 are driven to generate heat, use of a silicon substrate as the substrate 61 enables efficient dissipation of the heat by utilizing heat transfer of the substrate 61. In addition, when the substrate 61 is cooled from the rear surface side by an air cooling mechanism or the like, the light emitting devices 69 as a heat source can be cooled efficiently.

Furthermore, from the viewpoint of the heat transfer, the thickness of the substrate 61 may be thin. For example, in the case of a silicon substrate, the standard thickness of 8-inch wafer is 725 $\mu$m, but may be thinned in a backgrinding process or the like. However, when multiple pieces of the OLED chip 53 are mounted on another device, a thinner substrate 61 may reduce the yield ratio due to breakage such as cracking at the time of handling. To avoid this, the substrate 61 can have a certain level of thickness.

For example, the thickness of the substrate 61 can be 200 $\mu$m to 700 $\mu$m. The thickness of the silicon substrate is more preferably 378 $\mu$m to 408 $\mu$m. For example, a silicon substrate thinned in a range of 378 $\mu$m to 408 $\mu$m by a back grinder may be used. Note that a switching element such as a transistor, a wiring layer and an interlayer insulating layer (not illustrated) may be disposed on the substrate 61, and the aforementioned thickness of the silicon substrate refers to the thickness of the substrate 61 excluding a structure of these wiring layer and interlayer insulating layer.

First Electrode

The first electrode 63 may be transparent, or may be opaque. When the first electrode 63 is opaque, the material for the first electrode 63 may be a metal material having 70% or higher reflectance in emission wavelength. As the material for the first electrode 63, metal such as Al or Ag, an alloy obtained by adding Si, Cu, Ni, Nd, or the like to those, or ITO, IZO, AZO, IGZO, or the like may be used. For the first electrode 63, e.g., a lamination structure of Ti/TiN/AlCu (the sum of film thicknesses is 65 nm) may be used.

Note that the emission wavelength here refers to the spectrum range emitted from the organic layer 66. When the first electrode 63 has a reflectance higher than a desired reflectance, the first electrode 63 may be a laminated electrode using a barrier electrode of metal such as Ti, W, Mo, Au, or its alloy, or may be a laminated electrode using a transparent oxide film electrode such as ITO or IZO electrode.

Meanwhile, when the first electrode 63 is a transparent electrode, a configuration may be adopted in which a reflective layer is further provided below the first electrode 63. As the material for the transparent electrode, e.g., ITO, IZO, AZO, IGZO may be used. For the purpose of optimizing the later-described optical distance, a configuration may be adopted in which an insulating film is further provided between the reflective layer and the transparent conductive film.

Second Electrode

The light emitting device 69 of the present embodiment emits light from the second electrode. Thus, the second electrode 67 is disposed on the organic layer 66, and has a semi-transparent property. The second electrode 67 may be a semi-transparent conductive layer having a property (e.g., a transflective property) to transmit part of the light reached on the surface and reflect the other part of the light. The material for the second electrode 67 can have a small work function. For example, alkali metal such as lithium, alkali earth metal such as calcium, or single metal such as aluminum, titanium, manganese, silver, lead, chrome or a mixture including these may be used.

Alternatively, as the material for the second electrode 67, an alloy in a combination of these single metals may be used. For example, magnesium-silver, aluminum-lithium, aluminum-magnesium, silver-copper, and zinc-silver may be used. Of these electrode materials, one type may be used singly, or two or more types may be used. The second electrode may have a single layer configuration, or a multi-layered configuration.

Above all, silver may be used, and to inhibit aggregation of silver, a silver alloy may be used. If aggregation of silver can be inhibited, the ratio of the alloy is not restricted. For example, the ratio may be 1:1. As a semi-transparent material, particularly, an alloy having the main component of magnesium or silver may be used. When the second electrode 67 have suitable transmittance and reflectance, a laminated configuration of layers having the aforementioned materials may be adopted. The second electrode 67 may be shared by a plurality of light emitting devices 69.

Using the second electrode 67 made of a semi-transparent material, a device may be formed which has a top emission configuration that satisfies the aforementioned interference conditions. The method of forming an electrode may be a vacuum evaporation method, and is not limited to a specific one, but when DC or AC sputtering method is used, the coverage of the film is suitable, and the resistance is likely to be decreased, which is advantageous.

For example, the second electrode 67 may have a lamination structure (the sum of film thickness is 15 nm) of magnesium and silver.

Either one of the first electrode 63 or the second electrode 67 may be individually disposed for each of the plurality of light emitting devices 69, and the other one may be continuous over the plurality of light emitting devices 69. Alternatively, the first electrode 63 and the second electrode 67 may be individually disposed on the plurality of light emitting devices 69.

In the present example embodiment, an example is shown in which the second electrode 67 is in common between the plurality of light emitting devices 69. Thus, the wires connected from a power supply wire to cathode 67 of the plurality of light emitting devices 69 can be reduced in number.

The second electrode 67 supplies current to the organic layer 66 through the wiring 64, thus can have a low resistance. When the resistance of the second electrode 67 as a common electrode is high, an increase in the drive voltage of the light emitting devices 69 or uneven luminance due to shading may occur, and the emission characteristics may be impaired. Thus, the portion (the notch portion 81) removed to reduce the area of the second electrode 67 may be an outer region rather than an inner region which may increase the above-mentioned resistance, the inner region being from the contact region 64 toward the light emitting region 60.

Organic Layer

The organic layer 66 is disposed on the first electrode 63, and can be formed by a known technique such as a vapor deposition method or a spin coating method.

The organic layer 66 may have at least a light emitting layer, and may include a plurality of layers. When an organic layer is an organic compound layer, as the plurality of layers, one of or a combination of a hole injection layer, a hole transport layer, an electron blocking layer, a light emitting layer, a hole-blocking layer, an electron transport layer, and an electron injection layer may be mentioned.

In the light emitting layer, a hole injected from an anode and an electron injected from a cathode are recombined in an organic layer, thus light is emitted. The configuration of the light emitting layer may be a single layer or multiple layers. One of the light emitting layers can have a red light emitting material, a green light emitting material, or a blue light emitting material, and white light can be obtained by mixing the light emission colors.

Some of the light emitting layers may have light emitting materials with a relationship of complementary colors, such as a blue light emitting material and a yellow light emitting material. In either case, the light with an emission wavelength according to the application may be emitted, and the emission wavelength can be adjusted by the light emitting materials using an organic light emitting device.

Alternatively, light with different colors may be emitted by changing the materials and configuration included in the light emitting layers for each light emitting device 69. The plurality of light emitting devices 69 may have a common light emitting layer, or each of the light emitting devices 69 may be provided with a light emitting layer. When each of the light emitting devices 69 is individually provided with a light emitting layer, the light emitting layer may be patterned for each light emitting device 69.

The light emitting device 69 according to the present embodiment may have a first reflective surface, a second reflective surface, and a light emitting layer disposed between the first reflective surface and the second reflective surface. The first reflective surface may be the first electrode 63, or may be a reflective layer disposed between the first electrode 63 and the insulating layer.

In order to optimize the optical distance between the first reflective surface and the light emission position of the organic layer 66 including the light emitting layer, let $Lr$ be the optical length from the upper surface of the first reflective surface to the light emission position of the organic layer 12, and $\Phi r$ be the phase shift at the reflective layer, then

$$Lr=(2m-(\Phi r/\pi))\times(\lambda/4)\cdots(1)$$

Where $m$ is an integer greater than or equal to 0. The film thicknesses of the first electrode 63 or the first reflective surface, and the organic layer 66 may be optimized to substantially satisfy the above Expression (1).

The optical distance $Ls$ from the light emission position to the second reflective surface substantially satisfies the following Expression (2), where $\Phi s$ is the phase shift when light with wavelength $\lambda$ is reflected on the reflective surface. In the present embodiment, $m' = 0$.

$$Ls=(2m'-(\Phi s/\pi))\times(\lambda/4)=-(\Phi s/\pi)\times(\lambda/4)\cdots(2)$$

Thus, full layer interference L substantially satisfies the following Expression (3).

$$L=Lr+Ls=(2m-\Phi/\pi)\times(\lambda/4)\cdots(3)$$

Here, $\Phi$ is the sum $\Phi r + \Phi s$ of the phase shifts when light with wavelength $\lambda$ is reflected on the first electrode 63 or the reflective layer, and the second electrode 67.

The above-stated "substantially satisfies" indicates that the tolerable range is approximately $\lambda/8$ or approximately 20 nm in Expression (1) to Expression (3).

Because the light emission position in the light emitting layer may be difficult to be identified, in the above configuration, the light emission position is substituted by the interface of the functional layer, near the first reflective surface or the interface of the functional layer, near the second reflective surface. When the above-mentioned tolerable range is taken into consideration, the effect of intensifying light can be achieved even if the light emission position is substituted in this manner.

In interference conditions for intensifying light, it is well known that a radiation light distribution from the light emitting device is modulated by a Lambertian distribution, thus forward direction components increase, and oblique direction components decrease. Thus, light emitting devices having a top emission configuration satisfying the interference conditions may be used to inhibit stray light, and improve resulting print quality.

For example, over the first electrode 63, the hole injection layer (film thickness of 8 nm), the hole transport layer (37 nm), the light emitting layer (20nm), the hole-blocking layer (34 nm), the electron transport layer (20 nm), and the electron injection layer (0.5 nm) may be laminated.

Contact Region and Pad

In the contact region 64a, the wiring 64 should secure electrical contact with the second electrode 67, and can be produced using metal materials such as aluminum (Al), titanium (Ti), and titanium nitride (TiN). In addition, mixed materials of these or a laminated configuration may be adopted.

When the organic layer 66 is deposited by a vapor deposition method or the like, electrical connection between the second electrode 67 and the wiring 64 should be secured, thus the organic layer 66 may partially cover the wiring 64. The pad 70 needs to be electrically connected to the head substrate 50 by wire bonding or the like, thus can be produced with the same material as that for the wiring 64.

Protective Layer

The protective layer 68 is an insulating layer, and has translucency, and may contain an inorganic material having low oxygen and moisture permeability from the outside. For example, the protective layer 68 can be produced using inorganic materials such as silicon nitride (SiN), silicon oxynitride (SiON), silicon oxide (SiOx), aluminum oxide (Al2O3), and titanium oxide (TiO2).

In particular, from the viewpoint of protective performance, the inorganic materials SiN, SiON, Al2O3 may be used. For formation of the protective layer 68, a chemical vapor deposition method (CVD method), an atomic layer deposition method (ALD method), or a sputtering method may be used. For example, after the second electrode is formed, the device substrate is transported to another chamber without breaking the vacuum, and a silicon nitride film with a thickness of 2 $\mu$m is formed by a CVD method, and the silicon nitride film may serve as a protective layer. After deposition of a film by the CVD method, a protective layer may be provided using an atomic layer deposition method (ALD method).

When the protective layer 68 has a sufficient moisture barrier property, the protective layer 68 may have a single layer structure, or a lamination structure in combination of the materials and formation techniques mentioned above. For example, a layer of silicon nitride, and a high density layer produced by an atomic layer deposition method may be laminated. Furthermore, when the protective layer 68 has a sufficient moisture block performance, it may have an organic layer. As the organic layer, e.g., polyacrylate, polyimide, polyester, epoxy may be mentioned. Furthermore, the protective layer 68 may be disposed over the plurality of light emitting devices 69.

For example, the device substrate is transported to another chamber with the vacuum maintained after formation of the second electrode 67, and the protective layer 68 may be produced by forming a silicon nitride film with a thickness of 2 $\mu$m by a CVD method.

An antireflection layer may be provided on the protective layer 68. The antireflection layer is formed so that the optical film thickness (product of refractive index and film thickness) of a film with a refractive index different from that of the protective layer 68 is $\lambda/4$, where $\lambda$ is the wavelength whose reflection is desired to be inhibited. However, the wavelength of the light emitted from each light emitting device 69 provides broad light emission in which the half-value width is large in general, as compared to a semiconductor laser.

Therefore, to obtain a sufficient antireflection effect over a broad emission wavelength, a multi-layered configuration is more advantageous than a single layer configuration. The material for the antireflection layer may be magnesium fluoride, or silicon oxide, or as in the planarizing layer, may be polymer. In consideration of the cost of manufacturing process related to film deposition, use of the later-described color filter should be appropriately selected.

Color Filter

In the present embodiment, an example has been shown, in which a color filter is not provided on the light emitting side of the light emitting device, however, a color filter may be provided on the protective layer. For example, a color filter for which the size of the light emitting device 69 is taken into consideration may be provided on another substrate, which may be bonded together with a substrate provided with the light emitting device, or a color filter may be patterned on the above-mentioned protective layer using photolithography. The color filter may be comprised of polymer. The color filter transmits desired light from the light emitting devices 69 and absorbs light with an unnecessary wavelength.

For display device application, a color filter can be provided to enhance the color purity for red, green, blue color light emitting devices. Alternatively, a color filter can be provided to separate the light from the white light emitting device to red, green, and blue.

When used for the exposure head of the image forming apparatus, a color filter may be used, which transmits the light having a wavelength for exposing the photoconductor drum. Meanwhile, for stray light, the arrangement of the color filter needs to be devised. For example, the light emitting region is not provided with a color filter, but a non-light emission region is provided with a color filter that absorbs the light from the light emitting device, thus the stray light can be absorbed without reducing the amount of light incident on the photoconductor drum.

Alternatively, the light emitting region 60 may be provided with a color filter that transmits the light with an emission wavelength, and the non-light emission region may be provided with a color filter that absorbs the light from the light emitting devices 69. By adopting such a configuration, the stray light can be absorbed without reducing the amount of light incident on the photoconductor drum. Note that the color filter provided in the non-light emission region may be a black resist.

Planarizing Layer

A planarizing layer may be provided between the color filter and the protective layer. The planarizing layer may be comprised of organic compounds, and may be either low molecular-weight polymer or a high molecular-weight polymer, but may be advantageously high molecular-weight polymer.

The planarizing layer may be provided above and below the color filter, and their constituent materials may be the same or may be different. Specifically, polyvinyl carbazole resin, polycarbonate resin, polyester resin, ABS resin, acrylic resin, polyimide resin, phenolic resin, epoxy resin, silicon resin, and urea resin may be used. Since the planarizing layer is also provided on the color filter, permeation of moisture and oxygen into the color filter from the outside can be reduced, and the color filter can be protected.

Second Example Embodiment

In the present embodiment, a configuration example when the OLED chip 53 of the first embodiment has a color filter will be described. Since the present embodiment is the same as the first embodiment except that a color filter is provided, a description is omitted. A color filter 91 can be produced, for example, by forming the planarizing layer 90 on the protective layer 68 to planarize irregularities of the protective layer 68, which occur due to the light emitting devices 69, and subsequently, using photolithography.

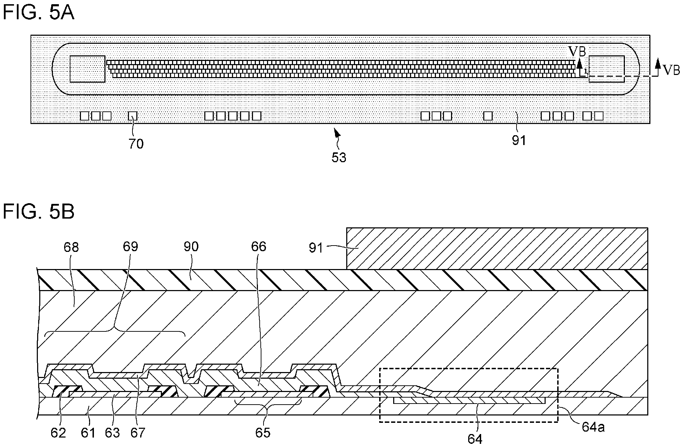

Fig. 5 illustrates an example in which the region excluding the light emitting region 60 and the pad 70 is provided with a first color filter 91 that absorbs the light from the light emitting devices 69. Fig. 5A is a plan view of the OLED chip 53, and Fig. 5B is a schematic view of a section taken along line VB-VB of Fig. 5A. Because the pad 70 needs to establish electrical connection, the color filter is not disposed on the pad 70.

On the light emitting devices 69, the first color filter 91 is not disposed, but a transparent planarizing layer 90 is provided. Thus, stray light from unintended direction can be absorbed without reducing the amount of light emitted from the OLED chip 53. The first color filter 91 may be a black resist that also absorbs the light other than the light with the emission wavelength from the light emitting devices 69.

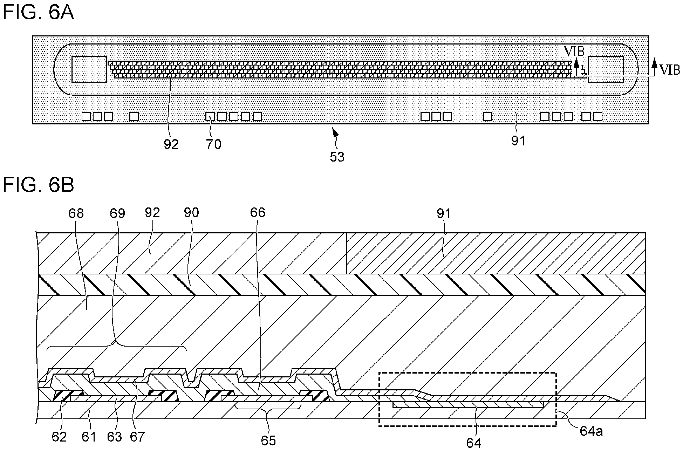

Figs. 6A and 6B illustrate an example in which the region excluding the pad 70 is provided with a color filter. Fig. 6A is a plan view of an example of part of the OLED chip 53, and Fig. 6B is a schematic view of a section taken along line VIB-VIB of the configuration of Fig. 6A. A second color filter 92 that transmits the light with the emission wavelength is provided on the light emitting devices 69, and the first color filter 91 that absorbs the light from the light emitting devices 69 is provided on the light emitting region 60 and the region excluding the pad 70. Consequently, stray light from unintended direction can be absorbed without reducing the amount of normal light emitted from the OLED chip. Note that the first color filter 91 may be a black resist that also absorbs the light other than the wavelength corresponding to the light from the light emitting devices 69.

Third Example Embodiment

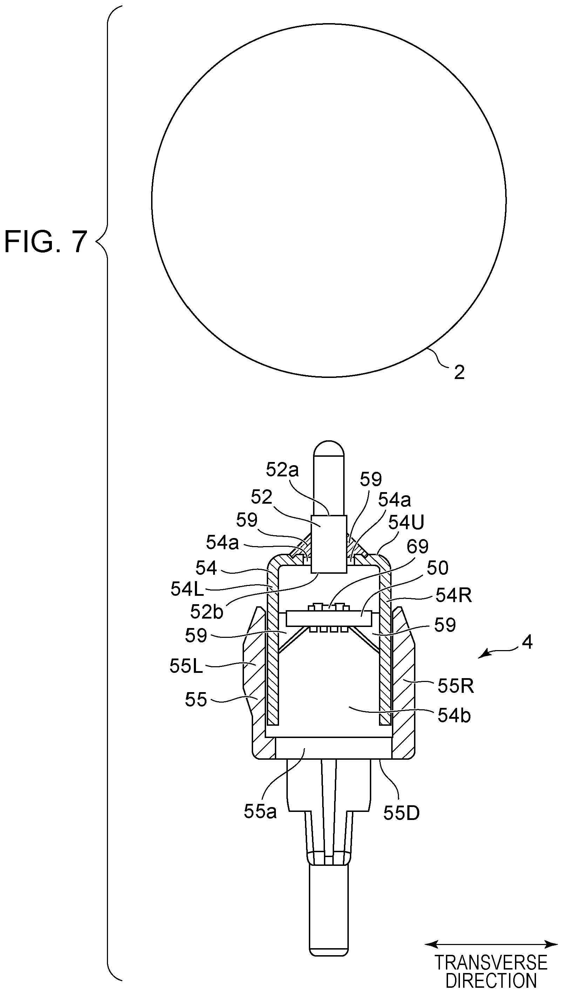

Next, referring to Fig. 7, an exposure head 4 will be described. Fig. 7 is a schematic sectional view of the exposure head 4 of the present embodiment. The exposure head 4 of the present embodiment includes the OLED chip 53 in the first or second embodiment.

The exposure head 4 has a long shape (longitudinal shape) extending in the axial direction of a photoconductor drum 2. The exposure head 4 includes a head substrate 50, light emitting devices 69 mounted on the head substrate 50, a lens array 52, and a holding member that holds the head substrate 50 and the lens array 52.

The holding member includes the later-described housing 54, and a housing support member 55 that supports the housing 54. Herein, the exposure head 4 includes a light emitting diode (LED) as a light emitting device that emits light, and e.g., an organic light emitting device may be used.

Housing

As illustrated in Fig. 7, the housing 54 holds the lens array 52 and the substrate 50. In the present embodiment, the housing 54 is a metal member formed by bending a plate material obtained by performing plating treatment on a galvanized steel sheet or a cold rolling steel sheet. Here, as an example of an exposure method used by an electrophotographic image forming apparatus, a laser beam scanning exposure method is known by which the irradiation beam of a semiconductor laser is scanned with a rotating polygon mirror, and the photoconductor drum is exposed via f-θ lens. The exposure head 4 described in the present embodiment is disposed adjacent to the photoconductor drum 2, and is utilized in an OLED exposure method that exposes the photoconductor drum 2 using the light emitting devices 69 arranged in the axial direction of the photoconductor drum 2.

The housing 54 can be made of metal, for example. For example, the housing 54 is obtained by shaping a plate such as a thin sheet made of iron into U-character shape by press working. The shape of the housing 54 will be described below.

A planar part 54U is opposed to the photoconductor drum 2 in the optical axis direction of the lenses of the lens array 52. Note that the planar part 54U is not limited to a planar surface, and may be a slightly curved surface. The housing 54 has an extending portion 54R that extends from one side of the transverse direction of the planar part 54U in a direction away from the photoconductor drum 2. The housing 54 has an extending portion 54L that extends from the other side of the transverse direction of the planar part 54U in a direction away from the photoconductor drum 2.

The extending portion 54R and the extending portion 54L form a substrate supporter that supports the head substrate 50 inserted through a second opening 54b in the housing 54. The planar part and the substrate supporter (the extending portions 54R, 54L) are an integral object, and constitute the housing 54 that holds the lens array 52 and the head substrate 50, and the housing 54 is substantially formed in U-character shape. Since the housing 54 is substantially formed in U-character shape, the second opening 54b is formed on the opposite side of the planar part 54U. The second opening 54b is formed between the substrate supporters (the extending portions 54L, 54R) that extend to the side away from the photoconductor drum from the planar part 54,.

The head substrate 50 is inserted through the second opening 54b, in other words, inserted from the lower side of the housing 54 in U-character shape, and bonded to the inner side of each substrate supporter (the inner side of the extending portion 54L and the inner side of the extending portion 54R) by an adhesive. The position of the head substrate 50 in the focus direction is determined by a jig which is not illustrated, thus the exposure head 4 is not provided with a positioning unit for them head substrate 50 in the focus direction.

In addition, the lens array 52 is also bonded to the planar part 54U by an adhesive with the lens array 52 inserted in the first opening 54a formed in the planar part 54U. After adjustment of the position in the focus direction and inclination is made by a jig so that the distance between all OLED chips 53 mounted on the head substrate 50 and the lens array 52 in the focus direction reaches a predetermined value, the lens array 52 is fixed to the planar part 54U (housing 54). The lens array 52 is fixed to the planar part 54U at multiple points in the longitudinal direction by an adhesive. In other words, in the longitudinal direction of the planar part 54U, the exposure head 4 in this example has multiple bonding points at which the lens array 52 inserted in the first opening 54a is bonded and fixed to the planar part 54U.

After position adjustment and fixing of the head substrate 50, the lens array 52 to the housing 54 is made, the gap between the substrate 50 inserted in the second opening 54b and the housing 54 (the extending portions 54L, 54R) is sealed by sealant 59 in the longitudinal direction. Thus, contamination of the light emitting devices 69 due to toner and dust from the outside is reduced. Here, the sealant 59 only seals the gap (boundary) between the substrate 50 and the housing 54, and most of FFC connector 57, and the head substrate 50 is exposed.

Similarly, the sealant 59 is applied to the gap between the lens array 52 inserted in the first opening 54a and the housing 54 (the planar part 54U), and the gap is sealed by the sealant 59 in the longitudinal direction. More specifically, as illustrated in Fig. 7, the sealant 59 seals the gap between the side wall of the lens array 52 in the longitudinal direction of the housing 54, and the edge of the first opening 54a. Consequently, it is possible to reduce the possibility of entry of powder dust such as toner through the gap between the side wall of the lens array 52 and the first opening 54a, and blocking of the light emitted from the light emitting devices 69 by the powder dust.

Note that the gap sealed by the sealant 59 is not limited to the gap between the side wall of the lens array 52 on one side and the edge of the first opening 54a, and the sealant 59 also seals the gap between the side wall of the lens array 52 on the other side and the edge of the first opening 54a. The side wall of the lens array 52 on the other side refers to the side wall on the opposite side to the side wall of the lens array 52 on one side. Also, the gap (e.g., boundary) between the housing 54 and the lens array 52 is sealed by the sealant 59. This reduces the occurrence of contamination of the light emitting devices 69 due to toner and dust from the outside.

As described above, the head substrate 50 and the lens array 52 are held by the housing 54, thus the light emitting devices 69 and the incident plane of the lens are opposed. Thus, the light emitted from the light emitting devices 69 enters the incident plane of the lens, and is emitted from the emission plane of the lens to the photoconductor drum 2 to expose the photoconductor drum 2.

Here, it is desirable that the light emitted from the light emitting devices 69 ideally enter the incident planes of all lenses, however, some light from the light emitting devices 69 is obliquely emitted because of the optical radiation distribution. For example, oblique light not directly incident on the lens array from the light emitting devices 69, but which is incident on the housing inner wall of the exposure head and reflected therefrom, is the light passing through an unintended path, and can be stray light. Also, the light which has been normally incident on the photoconductor drum 2 from the light emitting devices 69 through the lens array 52, may be reflected on the surface of the photoconductor drum 2 or scattered by the toner and/or powder and/or dust which may be present in the optical path. In addition, Fresnel reflection may occur at the end face of the lens array. When these rays of light pass through the lens array again, and are further reflected by the second electrode 67 of the light emitting devices 69, the light may become stray light.

When the light emitting device 69 is an organic light emitting device, in a top emission configuration, what primarily contributes to reflection is the second electrode having a high reflectance, which is located on the same side as the lens array and closest to the organic layer 66. In order to reduce the above-mentioned stray light, the area of the second electrode may be reduced as much as possible without impairing the emission characteristics of the organic light emitting device.

Therefore, in the exposure head 4 of the present embodiment, as compared to when the second electrode has no notch portion, the area of the second electrode 67 can be reduced using the OLED chip 53 according to the first or second embodiment, thus stray light can be reduced. Since the stray light can be reduced, when the exposure head 4 is used in the image forming apparatus, ghost spots due to stray light can be reduced in number, and print quality can be improved.

Housing Support Member

The housing support member 55 supports the housing 54 in the longitudinal direction, and is provided integrally with the housing 54, the housing 54 holding the head substrate 50 and the lens array 52. The housing support member 55 is a longitudinal-shaped member extending in the axial direction of the photoconductor drum 2. As illustrated in Fig. 7, the housing support member 55 is formed in U-character shape. The housing support member 55 includes: a left-side wall 55L that is a first side wall; a right-side wall 55R that is a second side wall opposed to the left-side wall 55L; and a bottom surface part 55D which is between the left-side wall 55L and the right-side wall 55R and opposed to the planar part 54U of the housing 54. The bottom surface part 55D of the housing support member 55 is provided with a plurality of openings 55a in the longitudinal direction which is the axial direction of the photoconductor drum 2.

The openings 55a of the housing support member 55 are provided at positions opposed to the surface (the rear surface of the head substrate 50) on the opposite side of the mounting surface (the surface of the head substrate 50) on which the light emitting devices 69 of the head substrate 50 are mounted. The openings 55a are provided between the left-side wall 55L and the right-side wall 55R in the transverse direction perpendicular to the longitudinal direction.

Substrate and Lens Array

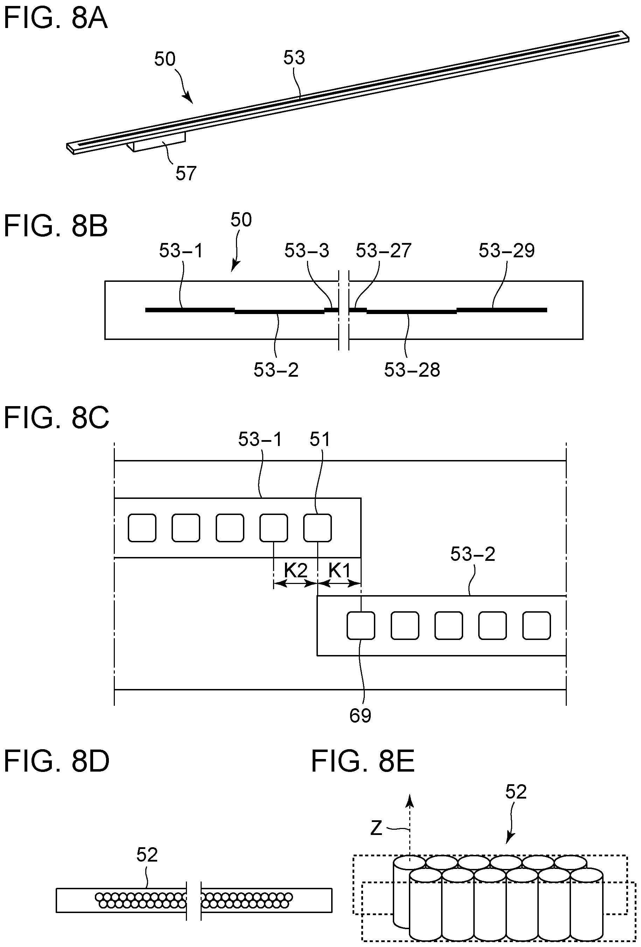

Here, the head substrate 50 of the exposure head 4 and the lens array 52 will be described with reference to Figs. 8A to 8E. First, the head substrate 50 will be described. Fig. 8A is a schematic perspective view of the head substrate 50. Fig. 8B illustrates the arrangement of the plurality of light emitting devices 69 provided in the head substrate 50, and Fig. 8C illustrates an enlarged view of Fig. 8B.

The OLED chips 53 are mounted on the head substrate 50. As illustrated in Fig. 8A, one surface of the head substrate 50 is provided with the OLED chips 53, and the other surface is provided with a long flexible flat cable (FFC) connector 57. The one surface of the head substrate 50 referred to herein is the surface (e.g., the upper surface, or the front surface) on the side where the OLED chips 53 are provided. The other surface of the substrate is the surface (e.g., the lower surface, or the rear surface) on the opposite side to the side where the OLED chips 53 are provided.

The FFC connector 57 is mounted on the other surface (the lower surface, the rear surface) of the head substrate 50 so that the longitudinal direction of the FFC connector 57 is in the longitudinal direction of the head substrate 50. The long FFC connector 57 is provided so that a control signal (e.g., a drive signal) is input from the control circuit of the apparatus body of the image forming apparatus, and the control signal is transferred to each OLED chip 53. The OLED chips 53 are driven (light emission, light off operation) by the control signal input to the head substrate 50.

The OLED chips 53 mounted on the head substrate 50 will be described. As illustrated in Fig. 8B and Fig 8C, a plurality of light emitting devices 69 is disposed on one surface of the head substrate 50. For example, OLED chips 53-1 to 53-29 (29 pieces) are arranged. In each of the OLED chips 53-1 to 53-29, the plurality of light emitting devices 69 is disposed in the longitudinal direction, and e.g., 516 pieces of light emitting devices 69 are arranged.

In the longitudinal direction of the OLED chip 53, the center-to-center distance k2 of adjacent light emitting devices 69 corresponds to the resolution of the image forming apparatus 100. For example, when the resolution of the image forming apparatus 100 in this example is assumed to be 1200 dpi, the light emitting devices 69 are arranged so that the center-to-center distance k2 between adjacent light emitting devices 69 is 21.16 μm in the longitudinal direction of the OLED chips 53-1 to 53-29. Thus, the exposure range of the exposure head 4 in this example is approximately 314 mm.

The photosensitive layer of the photoconductor drum 2 is formed with a width of 314 mm or more. Since the length of the long side of A4 size recording paper and the length of the short side of A3 size recording paper are 297 mm, the exposure head 4 in this example has an exposure range which allows an image to be formed on A4 size recording paper and A3 size recording paper. Although Figs. 8A to 8E illustrate an example in which multiple pieces of light emitting device 69 are arranged in the longitudinal direction, the light emitting devices 69 may be arranged in the transverse direction in addition to the longitudinal direction.

The OLED chips 53-1 to 53-29 are arranged in the axial direction of the photoconductor drum 2. Specifically, the OLED chips 53-1 to 53-29 are alternately disposed so as to form two rows in the axial direction of the photoconductor drum 2. Specifically, as illustrated in Fig. 8B, the OLED chips 53-1, 53-3, ... 53-29 at odd number's position counted from the left side are mounted in a row in the longitudinal direction of the substrate 50. The OLED chips 53-2, 53-4, ... 53-28 at even number's position counted from the left side are mounted in a row in the longitudinal direction of the substrate 50. The OLED chips 53 are arranged in this manner.

Thus, as illustrated in Fig. 8C, in the longitudinal direction of the OLED chips 53, the center-to-center distance k1 between the light emitting devices 69 disposed at one end of one OLED chip 53 and the other end of the other OLED chip 53 in adjacent different OLED chips 53 can be made equal to the center-to-center distance k2 between adjacent light emitting devices 69 on one OLED chip 53.

Note that in the present embodiment, the light emitting device 69 is an organic light emitting device as well as a current-driven light emitting device. The organic light emitting devices are disposed on a line e.g., on a thin film transistor (TFT) substrate in the main scanning direction (the axial direction of the photoconductor drum 2), and similarly, are electrically connected in parallel by a power supply wire provided in the main scanning direction.

Next, the lens array 52 which is a lens assembly will be described. Fig. 8D is a schematic view when the lens array 52 is seen from the photoconductor drum 2. Fig. 8E is a schematic perspective view of the lens array 52. As illustrated in Fig. 8D, the lens array 52 focuses the light emitted from the light emitting devices 69 to the photoconductor drum 2. The lens array 52 is a lens assembly having a plurality of lenses.

The plurality of these lenses is arranged in two rows in the arrangement direction of the plurality of light emitting devices 69. The lenses are alternately disposed so that adjacent lenses in the arrangement direction of the lens in one row are both in contact with one of the lenses in the other row. Each lens is a cylindrical rod lens made of glass, and includes: a light incident plane 52b on which the light emitted from the light emitting device 69 is incident; and a light emission plane 52a from which the light entered from the light incident plane is emitted (see Fig. 7). Note that the material for the lens is not limited to glass, and may be plastic. The shape of the lens is not limited to cylindrical shape, and may be, for example, a polygonal prism such as a hexagonal prism.

A dotted line Z illustrated in Fig. 8E indicates the optical axis of the lens. The optical axis of a lens referred to herein indicates the line connecting the center of the light emission plane of the lens and the focal point of the lens. The lens array 52 is a lens assembly having a plurality of lenses, and the aforementioned "optical axis" is the optical axis of any one of the plurality of lenses. In a strict sense, the plurality of lenses in the lens array 52 may be slightly inclined to each other. This is due to the tolerance at the time of assembly.

However, deviation of approximately the level of tolerance referred to herein is not taken into consideration when the direction of the optical axis is defined. Thus, respective optical axes of the plurality of lenses are assumed to be in the same direction. The lens array 52 has a function of focusing the light emitted from the light emitting devices 69 onto the surface of the photoconductor drum 2.

The mounting position of the lens array 52 with respect to the housing 54 is adjusted at the time of assembly of the exposure head 4 so that the distance between the light emitting surface of the light emitting device 69 and the light incident plane of the lens is approximately equal to the distance between the light emission plane of the lens and the surface of the photoconductor drum 2.

As illustrated in Fig. 8B, in the exposure head 4, multiple OLED chips 53 are disposed on the exposure head substrate 50. Thus, because the area of the second electrode 67 in the OLED chips 53 can be decreased, in the entire exposure head 4, the area which contributes to reflection of unintended light due to the second electrode 67 is reduced in proportion to the number of OLED chips 53. Therefore, half or more of the disposed OLED chips 53 may be the OLED chips 53 according to the first or second embodiment, and all of the disposed OLED chips 53 may be the OLED chips 53 according to the first or second embodiment.

The present embodiment shows an example of so-called a staggered arrangement in which the OLED chips 53 are alternately disposed so as to form two rows.

As seen in Fig. 8C, a region is formed where the ends of two OLED chips 53 are superimposed in the longitudinal direction. The region corresponds to a portion where the end of the second electrode 67 of an OLED chip is present, thus the reflection area locally increases in the region of the entirety of the exposure head 4. Thus, the reflection area in the superimposed region can be reduced by decreasing the area of the second electrode 67 at the end of the second electrode 67, therefore stray light due to reflection of unintended light can be effectively reduced.

When an OLED chip is used for the exposure head 4, exposure is performed linearly, thus as compared to when an OLED chip is used for a display device or the like, the shape of the light emitting region 60 has a higher ratio of length in the longitudinal direction (the first direction X) to length in the transverse direction (the second direction Y). In addition, the shape of the substrate of the OLED chip also has a higher ratio of length in the longitudinal direction (the first direction X) to length in the transverse direction (the third direction Y).

Specifically, for example, the length of the long side of the OLED chip (or the light emitting region 60) is greater than or equal to five times the length of the short side of the OLED chip (or the light emitting region 60), and may be greater than or equal to 10 times the length of the short side. For example, the length of the long side of the OLED chip (or the light emitting region 60) can be greater than or equal to 20 times the length of the short side of the OLED chip (or the light emitting region 60).

The length of the long side of the OLED chip is determined by the axial length of the photoconductor drum 2, the number of OLED chips disposed in the axial direction, and the manner of arrangement of the OLED chips 53. The length of the short side of the OLED chip is determined by whether the light emitting devices 69 are disposed on the light emitting region 60 in a direction perpendicular to the axis of the photoconductor drum 2, and arrangement of the pad 70 and the contact regions 64a.

It is known that an organic light emitting device dissipates heat according to the length of light emission time and the magnitude of the amount of light emission. Such heat causes thermal expansion of a circuit board in which an organic light emitting device is formed and the head substrate 50 on which multiple light emitting device are mounted, and deviation of a relative positional relationship between the lens array and the light emitting devices 69 may increase the ratio of the stray light to the normal light.

When the normal light mainly serving for exposure decreases, the ratio of the stray light to the normal light increases, thus deterioration of the print quality might be caused.

Thus, in a configuration in which multiple pieces of the OLED chip 53 are mounted on the head substrate 50, even when the light emitting devices 69 formed on the substrate 61 are driven to generate heat, use of a silicon substrate as the substrate 61 efficiently transmits the heat to the head substrate 50 through the substrate 61. On the other hand, it is advantageous in that when the head substrate 50 is cooled from the rear surface side by an air-cooling mechanism, the light emitting device 69 as a heat source can be efficiently cooled.

In consideration of the wavelength dependence of the exposure sensitivity of the photoconductor drum 2, the organic layer 66 may be configured to include a light emitting layer that emits red light.

The OLED chip 53 may have a color filter as illustrated in the second embodiment. Due to the color filter, stray light from unintended direction can be absorbed without reducing the amount of normal light incident on the photoconductor drum 2, thus print quality can be improved.

Fourth Example Embodiment

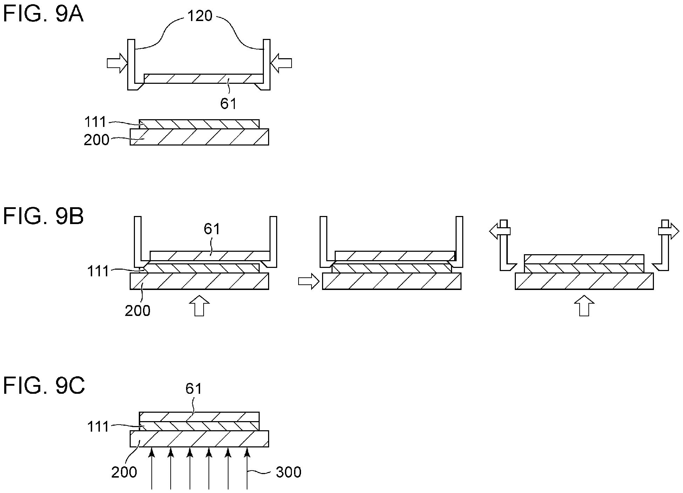

Next, part of a manufacturing process of the OLED chip 53 will be described with reference to Figs. 9A to 9C, but the present disclosure is not limited to this.

In a vapor deposition chamber, for example, with the configuration below, the second electrode 67 of the OLED chip 53 in the first embodiment and the second embodiment can be formed on the substrate 61. A method of manufacturing part of the OLED chip 53 includes: a process for arranging a vapor deposition mask having a plurality of openings to be opposed to a substrate on which a first electrode and an organic layer are disposed; and a process for positioning the substrate with respect to the vapor deposition mask. The method of manufacturing part of the OLED chip 53 further includes a process for forming a second electrode by depositing a vapor deposition material on the substrate through the openings of the vapor deposition mask.

Here, the openings of the vapor deposition mask each have a long side extending in first direction X, a short side extending in second direction Y' intersecting the first direction X, and a portion at the end in the first direction X, the portion being non-parallel to the third direction Y intersecting the first direction X.

First, as illustrated in Fig. 9A, the substrate 61 held by a substrate holding arm 120 is made opposed to a vapor deposition mask 111 disposed on a mask stage 200 and having a plurality of openings. A first electrode 63, an insulating layer 62, and an organic layer 66 are formed on the substrate 61. In addition, wiring 64, a pad 70, and a circuit to drive the light emitting devices 69 may be formed.

Next, as illustrated in Fig. 9B, either one or both of the substrate 61 and the vapor deposition mask 111 are moved to position the substrate 61 with respect to the vapor deposition mask 111. Subsequently, as illustrated in Fig. 9C, the second electrode 67 is formed on the substrate 61 by depositing a vapor deposition material 300 on the substrate 61 through a plurality of openings of the vapor deposition mask 111.

In the vapor deposition mask 111, the plurality of openings has a long side extending in first direction X, a short side extending in second direction Y' intersecting the first direction X, and a portion at the end in the first direction X, the portion being non-parallel to third direction Y intersecting the first direction X. Therefore, the second electrode 67 deposited through the openings also have a long side extending in the first direction X, a short side extending in the second direction Y' intersecting the first direction X, and a portion at each end in the first direction X, the portion being non-parallel to the third direction Y intersecting the first direction X.

Therefore, as compared to when the second electrode 67 does not have a portion non-parallel to the third direction Y at the end in the first direction X, the area of the second electrode 67 can be reduced. Thus, the effect on the light emission characteristics of the OLED chip 53 due to reflection of unintended light by the second electrode, and occurrence of stray light in the exposure head 4 having OLED chips 53 can be reduced. Therefore, when the exposure head 4 of the present embodiment is used for an image forming apparatus, ghost spots due to stray light can be reduced in number, and print quality can be improved.

The manufacturing device for the OLED chip 53 herein is an example, and the present disclosure is not limited to this. The light emitting device 69 has a plurality of functional layers, and a vapor deposition device that is a manufacturing device for the light emitting device 69 includes a large number of vapor deposition chambers corresponding to the plurality of functional layers. In addition to the vapor deposition chamber, the vapor deposition device may include a plurality of process chambers such as a preparation chamber, a pre-treatment chamber, a transport chamber, a relay chamber, and a substrate stock chamber.

Fifth Example Embodiment

Image Forming Apparatus

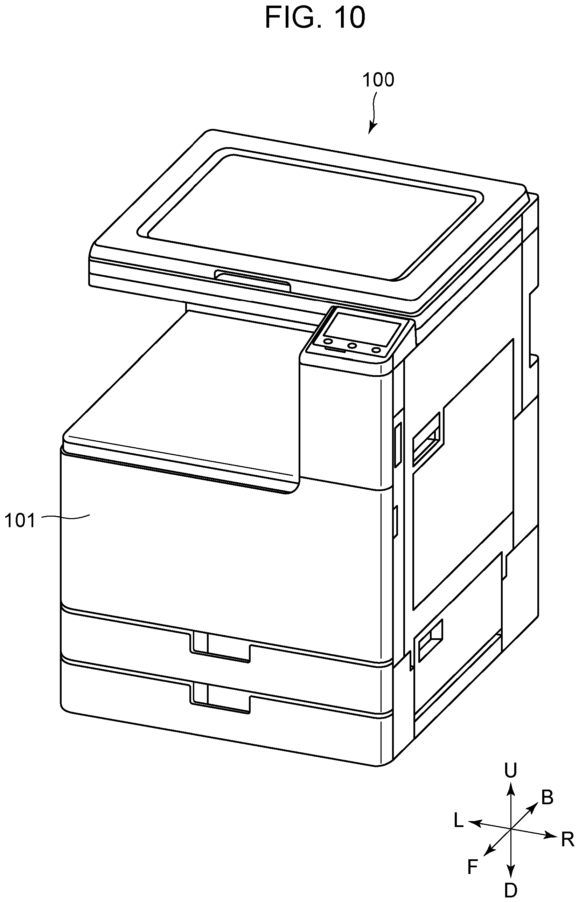

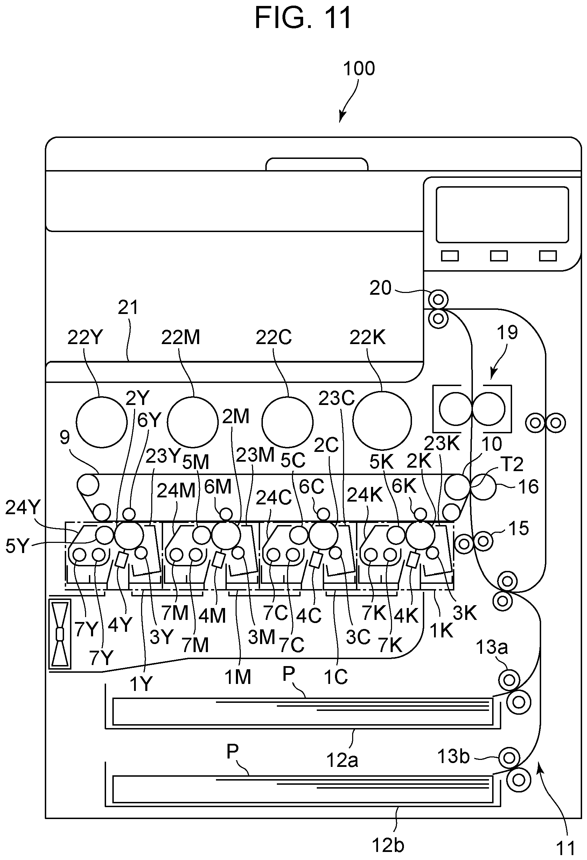

First, the schematic configuration of an image forming apparatus 100 will be described with reference to Fig. 10 and Fig. 11. Fig. 10 is a perspective view of the image forming apparatus 100. Fig. 11 is a schematic sectional view of the image forming apparatus in Fig. 10. Although the image forming apparatus 100 illustrated in Fig. 10 and Fig. 11 is a copier including a reading device, the embodiment may be another image forming apparatus, such as a printer including no reading device. In addition, the embodiment is not limited to the color image forming apparatus including a plurality of photoconductor drums 2, and may be a color image forming apparatus including one photoconductor drum 2 or an image forming apparatus that forms a monochrome image.

The image forming apparatus 100 illustrated in Fig. 11 includes four image formers 1Y, 1M, 1C, 1K (hereinafter may also be simply referred to as "image former 1" collectively) that form toner images of each color of yellow, magenta, cyan, and black.

The image formers 1Y, 1M, 1C, 1K respectively include photoconductor drums 2Y, 2M, 2C, 2K (hereinafter may also be simply referred to as "photoconductor drum 2" collectively) which are each an example of a photoreceptor. The photoconductor drum 2 may be a photoconductor belt.

In addition, the image formers 1Y, 1M, 1C, 1K include charging rollers 3Y, 3M, 3C, 3K (hereinafter may also be simply referred to as "charging roller 3" collectively) as charging units, configured to charge the photoconductor drums 2Y, 2M, 2C, 2K, respectively.

In addition, the image formers 1Y, 1M, 1C, 1K include organic light emitting diode (hereinafter denoted as OLED) exposure heads 4Y, 4M, 4C, 4K (hereinafter may also be simply referred to as "exposure head 4" collectively) as exposure units, configured to expose the photoconductor drums 2Y, 2M, 2C, 2K.

The image formers 1Y, 1M, 1C, 1K further include developing units 24Y, 24M, 24C, 24K (hereinafter may also be simply referred to as "developing unit 24" collectively) as developing units, configured to develop toner images of each color on the photoconductor drum 2 by developing an electrostatic latent image on the photoconductor drum 2 with toner. Note that Y, M, C, K suffixed to symbol indicate the color of toner.

The image forming apparatus 100 illustrated in Fig. 11 is an image forming apparatus adopting so-called "lower surface exposure system" by which the photoconductor drum 2 is exposed from below. A description will be given below assuming that the image forming apparatus adopts the lower surface exposure system. Although illustration is not provided, as the embodiment, the image forming apparatus may adopt "upper surface exposure system" by which the photoconductor drum is exposed from above.

The image forming apparatus 100 includes: an intermediate transfer belt 9 onto which a toner image formed on the photoconductor drum 2 is transferred; and first transfer rollers 6 (Y, M, C, K) that successively transfer the toner image formed on the photoconductor drum 2 onto the intermediate transfer belt 9. The intermediate transfer belt 9 is disposed above the image former 1. Note that instead of the intermediate transfer system using the intermediate transfer belt 9, a direct transfer system may be adopted by which a toner image is directly transferred from the photoconductor drum 2 onto a sheet.

In addition, the image forming apparatus 100 includes: a second transfer roller 16 as a transfer unit configured to transfer a toner image on the intermediate transfer belt 9 onto recording paper P transported from a feeding unit 11; and a fuser 19 as a fixing unit that fixes a secondly transferred image onto recording paper P.

Toner bottles 22Y, 22M, 22C, 22K (hereinafter may also be simply referred to as "toner bottle 22" collectively) that store refill toner of each color are attachable and detachable units to and from the image forming apparatus 100. The toner bottle 22 is disposed above the intermediate transfer belt 9. An appropriate amount of toner is supplied as needed to each developing unit included in the four image formers from a corresponding toner bottle 22 by a toner supply mechanism which is not illustrated.

The image forming apparatus 100 includes the feeding unit 11 that feeds recording paper P. The feeding unit 11 includes: sheet cassettes 12a, 12b; feeding rollers 13a, 13b; and a resist roller 15. The sheet cassettes 12a, 12b are disposed below the image former 1. Recording paper P stored in the sheet cassettes 12a, 12b is fed one by one by the feeding rollers 13a, 13b, and transported to a second transfer section T2 at a predetermined timing by the resist roller 15.

Image Formation Process

Next, the image formation process of the image forming apparatus 100 will be briefly described. The charging roller 3Y charges the surface of the photoconductor drum 2Y. The exposure head 4Y exposes the surface of the photoconductor drum 2Y charged by the charging roller 3Y. Thus, an electrostatic latent image is formed on the photoconductor drum 2Y. Next, the developing unit 24Y develops the electrostatic latent image formed on the photoconductor drum 2Y with yellow toner.

A yellow toner image developed on the surface of the photoconductor drum 2Y is transferred onto the intermediate transfer belt 9 by the first transfer roller 6Y. Magenta, cyan, black toner images are also formed by a similar image formation process, and transferred onto the intermediate transfer belt 9 so as to be superimposed.

The toner images of each color transferred onto the intermediate transfer belt 9 are transported to the second transfer section T2 by the intermediate transfer belt 9. The toner images transported to the second transfer section T2 are collectively transferred by the second transfer roller 16 to the recording paper P transported from the feeding unit 11. The recording paper P with transferred toner images is transported to the fuser 19. The fuser 19 fixes the toner images to the recording paper P by heat and pressure. The recording paper P which has undergone the fixing process by the fuser 19 is outputted by an output roller 20 to an output tray 21 disposed above the toner bottle 22. Evaluation of the print quality of printing on the recording paper P can be made by visual sensory evaluation.

Sixth Example Embodiment

In the present embodiment, an example of light emitting device 69 used in the OLED chip according to one of the first to fifth embodiments will be described. Configuration of Organic Light Emitting Device
An organic light emitting device as an example of light emitting device 69 is provided by forming an insulating layer, a first electrode, an organic compound layer, and a second electrode on the substrate. On the cathode, a protective layer, a color filter, and a micro lens may be provided. When a color filter is provided, a planarizing layer may be provided between the protective layer and the color filter. The planarizing layer may be made of an acrylic resin. The same applies when a planarizing layer is provided between the color filter and the micro lens.

Substrate

As the substrate, quartz, glass, silicon wafer, resin, and metal may be mentioned. On the substrate, a switching element such as a transistor, and wiring may be provided, and an insulating layer may be provided thereon. The material for the insulating layer is not limited as long as contact holes can be formed to enable wiring to the first electrode and insulation from wiring not to be connected can be secured. For example, a resin such as polyimide, silicon oxide, and silicon nitride may be used. The heat generated from the light emitting device can be efficiently dissipated using a silicon substrate.

Electrode

A pair of electrodes can be used as an electrode. The pair of electrodes may be an anode and a cathode. When an electric field is applied in the direction in which an organic light emitting device emits light, the electrode with a higher potential is the anode, and the other is the cathode. It is also can be stated that the electrode that supplies holes to a light emitting layer is the anode, and the electrode that supplies electrons is the cathode.

The constituent material for the anode may have a large work function as much as possible. For example, it is possible to use single metal such as gold, platinum, silver, copper, nickel, palladium, cobalt, selenium, vanadium, tungsten, or a mixture including these, an alloy combining these, or a metal oxide such as tin oxide, zinc oxide, indium oxide, indium tin oxide (ITO), or indium zinc oxide. In addition, a conductive polymer such as polyaniline, polypyrrole, or polythiophene may also be used.

Of these electrode materials, one type may be used singly, or two or more types may be used in combination. The anode may be formed by one layer, or formed by multiple layers.

When used as a reflective electrode, e.g., chrome, aluminum, silver, titanium, tungsten, molybdenum, or an alloy of these, or lamination of these may be used. With the above-mentioned materials, it is possible to achieve a function of a reflective film having no function as an electrode. When used as a transparent electrode, a transparent conductive layer of oxide such as indium tin oxide (ITO) or indium zinc oxide may be used, but not limited thereto. Photolithography may be used to form an electrode.

Meanwhile, the constituent material for the cathode may have a small work function. For example, alkali metal such as lithium, alkali earth metal such as calcium, or single metal such as aluminum, titanium, manganese, silver, lead, or chrome or a mixture including these may be used. Alternatively, an alloy in a combination of these single metals may be used. For example, magnesium-silver, aluminum-lithium, aluminum-magnesium, silver-copper, and zinc-silver may be used. It is also possible to utilize metal oxide such as indium tin oxide (ITO). Of these electrode materials, one type may be used singly, or two or more types may be used in combination. The cathode may have a single layer configuration, or a multi-layered configuration. Above all, silver may be used, and to reduce aggregation of silver, a silver alloy may be used. If aggregation of silver can be reduced, the ratio of the alloy is not limited. For example, the ratio of silver to the other metal may be 1:1 or 3:1.

The cathode may be a top emission device using an oxide conductive layer such as ITO or silver having a film thickness with semi-transparent property, or may be a bottom emission device using a reflective electrode such as aluminum (Al), and is not limited to a specific one. The method of forming a cathode is not limited to a specific one, but when DC or AC sputtering method is used, the coverage of the film is suitable, and the resistance is likely to be decreased, which is advantageous. In either case of the top emission device or the bottom emission device, the area of the second electrode can be reduced by conforming the second electrode to the shape according to the first or second embodiment, the second electrode having a high reflectance and serving as a common electrode.

Pixel Separation Layer

A pixel separation layer is comprised of a silicon nitride (SiN) film, a silicon oxynitride (SiON) film, or a silicon oxide (SiOx) film which is produced using a chemical vapor deposition method (CVD method). In order to increase the in-plane direction resistance of an organic compound layer, the organic compound layer, particularly, the hole transport layer may be thinly deposited on the side wall of a pixel separation layer. Specifically, a film having a small thickness can be formed on the side wall by increasing the taper angle at the side wall of the pixel separation layer and/or the film thickness of the pixel separation layer to increase occurrence of vignetting at the time of vapor deposition.

Meanwhile, the side wall taper angle of the pixel separation layer and the film thickness of the pixel separation layer may be adjusted so that a void is not created in the protective layer formed on the pixel separation layer. Since a void is not created in the protective layer, occurrence of defect in the protective layer can be reduced. Because occurrence of defect in the protective layer is reduced, it is possible to reduce reliability deterioration such as occurrence of a dark spot and occurrence of poor conductivity of the second electrode.

According to the present embodiment, even if the taper angle at the side wall of the pixel separation layer is not steep, charge leakage to adjacent pixels can be effectively reduced. As a result of study, it has been found that when the taper angle is in a range from 60 degrees to 90 degrees, charge leakage can be sufficiently reduced. The film thickness of the pixel separation layer is preferably 10 nm or greater and 150 nm or less. A similar effect is obtained even when the configuration includes only pixel electrodes having no pixel separation layer. However, in this case, the film thickness of each pixel electrode may be half or less of the thickness of the organic layer, or the ends of the pixel electrode may be forward tapered with less than 60° because short circuit of the organic light emitting device can be reduced in this manner.

Organic Compound Layer

The organic compound layer may be formed in a single layer or formed in multiple layers. When multiple layers are provided, each layer may be called a hole injection layer, a hole transport layer, an electron-blocking layer, a light emitting layer, a hole-blocking layer, an electron transport layer, or an electron injection layer depending on its function. The organic compound layer primarily includes organic compounds, but may include inorganic atoms, or inorganic compounds. The organic compound layer may contain e.g., copper, lithium, magnesium, aluminum, iridium, platinum, molybdenum, zinc. The organic compound layer may be disposed between the first electrode and the second electrode, and may be disposed in contact with the first electrode and the second electrode.

When multiple light emitting layers are provided, an electric charge generator may be provided between the first light emitting layer and the second light emitting layer. The electric charge generator may include an organic compound whose lowest unoccupied molecular orbital (LUMO) energy is -5.0 eV or less. The same applies when an electric charge generator is provided between the second light emitting layer and the third light emitting layer.

Protective Layer

A protective layer may be provided on the second electrode. For example, entry of moisture into the organic compound layer is reduced by bonding glass provided with hygroscopic agents onto the second electrode, thus occurrence of display defect can be reduced. In another embodiment, entry of moisture into the organic compound layer may be reduced by providing a passivation film such as silicon nitride on the cathode. For example, after the cathode is formed, the device substrate is transported to another chamber without breaking the vacuum, and a silicon nitride film with a thickness of 2 $\mu$m is formed by a CVD method, and the silicon nitride film may serve as a protective layer. After deposition of a film by the CVD method, a protective layer may be provided using an atomic layer deposition method (ALD method). The material for the film by the ALD method is not limited, but may be silicon nitride, silicon oxide, aluminum oxide or the like. On the film formed by the ALD method, a silicon nitride may be further formed by the CVD method. The film formed by the ALD method may be less in thickness than the film formed by the CVD method. Specifically, may be 50% or less, or 10% or less.

Color Filter

A color filter may be provided on the protective layer. For example, a color filter for which the size of the organic light emitting device is taken into consideration may be provided on another substrate, which may be bonded together with a substrate provided with the organic light emitting device, or a color filter may be patterned on the protective layer mentioned above using photolithography. The color filter may be comprised of a polymer material.

Planarizing Layer

A planarizing layer may be provided between the color filter and the protective layer. The planarizing layer is provided for the purpose of reducing the irregularities of the lower layer. A planarizing layer may be called a material resin layer without limiting its purpose. The planarizing layer may be comprised of organic compounds, and may be either low molecular-weight polymer or a high molecular-weight polymer, however, can be high molecular-weight polymer.

The planarizing layer may be provided above and below the color filter, and their constituent materials may be the same or may be different. Specifically, polyvinyl carbazole resin, polycarbonate resin, polyester resin, ABS resin, acrylic resin, polyimide resin, phenolic resin, epoxy resin, silicon resin, and urea resin may be mentioned.

Micro Lens

An OLED chip may have an optical member such as a micro lens on the light emitting side. The micro lens is made of an acrylic resin, an epoxy resin or the like. The micro lens may have objective of controlling increase in the amount of light taken out from the organic light emitting device, and the direction of the light to be taken out. The micro lens may have the shape of a hemisphere. When the micro lens has the shape of a hemisphere, among tangent lines to the hemisphere, a tangent line is parallel to the insulating layer, and the tangent point between the tangent line and the hemisphere gives the vertex of the micro lens. The vertex of the micro lens can be similarly determined in any section. Specifically, among tangent lines to a semicircle of the micro lens in the section, a tangent line is parallel to the insulating layer, and the tangent point between the tangent line and the semicircle gives the vertex of the micro lens.

The midpoint of the micro lens can be defined. In a section of the micro lens, the line segment from a point where the shape of an arc ends to a point where the shape of another arc ends is assumed, and the midpoint of the line segment can be called the midpoint of the micro lens. The section to determine the vertex, and the midpoint may be a section perpendicular to the insulating layer.

The micro lens has a first surface having a convex portion, and a second surface opposite to the first surface. The second surface can be disposed closer to the functional layers than the first surface. In order to adopt such a configuration, the micro lens needs to be formed on the light emitting device. When a functional layer is an organic layer, a process in a state of high temperature can be avoided in the manufacturing process. When a configuration is adopted in which the second surface is disposed closer to the functional layers than the first surface, all glass transition temperatures of the organic compounds included in the organic layer are preferably 100°C or higher, and more preferably 130°C or higher.

Opposite Substrate

An opposite substrate may be provided on the planarizing layer. The opposite substrate is called so because it is provided at a position opposed to the above-described substrate. The constituent material for the opposite substrate may be the same as that of the above-described substrate. When the above-described substrate is a first substrate, the opposite substrate may be a second substrate. If the opposite substrate is unnecessary, it may not be disposed.

Organic Layer

The organic compound layers (such as the hole injection layer, the hole transport layer, the electron blocking layer, the light emitting layer, the hole-blocking layer, the electron transport layer, and the electron injection layer) included in the organic light emitting device according to an embodiment of the present disclosure are formed by the method shown below.

A dry process such as a vacuum evaporation method, an ionized vapor deposition method, sputtering, or plasma may be used for the organic compound layers included in the organic light emitting device according to an embodiment of the present disclosure. Instead of a dry process, a wet process may be used in which solute is dissolved in an appropriate solvent, and a layer is formed by a known coating method (e.g., spin-coating, dipping, cast method, LB method, ink jet method).

When a layer is formed by a vacuum evaporation method or a solution coating method, crystallization is unlikely to occur, thereby achieving excellent temporal stability. When a film is deposited by a coating method, the film can be formed in combination with an appropriate binder resin.

As the aforementioned binder resin, polyvinyl carbazole resin, polycarbonate resin, polyester resin, ABS resin, acrylic resin, polyimide resin, phenolic resin, epoxy resin, silicon resin, and urea resin may be mentioned, but the binder resin is not limited to these.

Of these binder resins, as homopolymer or copolymer, one type may be used singly, or two or more types may be used in a mixed manner. In addition, as necessary, an additive agent such as a known plasticizing agent, an antioxidizing agent, or an ultraviolet absorbing agent may be used together.

Pixel Circuit

An OLED chip may have a pixel circuit connected to in light emitting device. The pixel circuit may be active-matrix type that performs light emission control on a first light emitting device, and a second light emitting device independently. An active-matrix circuit may be a voltage programming circuit or a current programming circuit. A drive circuit has a pixel circuit for each pixel. The pixel circuit may include: a light emitting device; a transistor that controls the emission luminance of the light emitting device; a transistor that controls light emission timing; a capacitor that holds the gate voltage of the transistor that controls the emission luminance; and a transistor for connecting to the GND not via the light emitting device.

An OLED chip includes a light emitting region, and a peripheral region disposed around the light emitting region. The light emitting region has a pixel circuit, and the peripheral region has a display control circuit. The mobility of the transistors included in the pixel circuit may be lower than the mobility of the transistors included in the display control circuit.

The slope of the current-voltage characteristics of the transistors included in the pixel circuit may be less than slope of the current-voltage characteristics of the transistors included in the display control circuit. The slope of the current-voltage characteristics can be measured with so-called Vg-Ig characteristics.

The transistors included in the pixel circuit are the transistors connected to light emitting devices, such as the first light emitting device.

Next, an example of part of an OLED chip according to the present embodiment will be described with reference to the drawings.

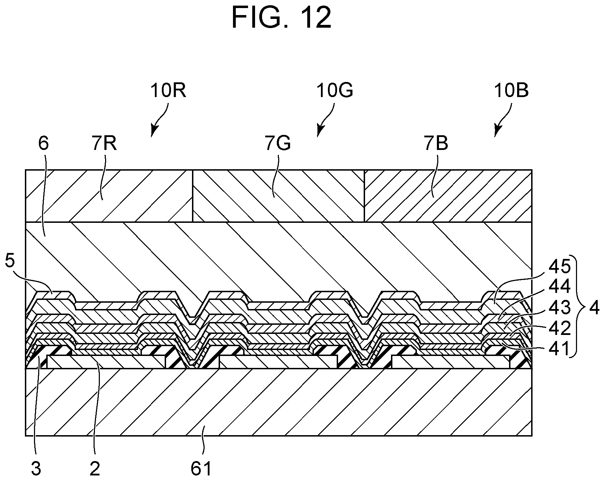

Fig. 12 is a sectional schematic view illustrating an example of an OLED chip having an organic light emitting device which is a light emitting device, and a transistor connected to the organic light emitting device.

The transistor is an example of an active element. The transistor may be a thin-film transistor (TFT).

Fig. 12 is an example of a pixel which is a component of an OLED chip according to the present embodiment. The pixel has a sub-pixel 10. The sub-pixel is divided into 10R, 10G, 10B according to its light emission color. Light emission color may be distinguished by the wavelength emitted from a light emitting layer, or the light emitted from a sub-pixel may undergo selective transmission or color conversion by a color filter or the like. In the present embodiment, three types of wavelength are distinguished by a color filter and light emission; however, when needed wavelengths have one type or two types, corresponding light emitting layer or color filter may each have one type or two types. Each sub-pixel includes: a reflective electrode 2 serving as a first electrode on an interlayer insulating layer 1; an insulating layer 3 that covers the end of the reflective electrode 2; an organic compound layer 4 that covers the first electrode and the insulating layer; a transparent electrode 5; a protective layer 6; and a color filter 7.

The interlayer insulating layer 1 includes a transistor, a capacitor element at a lower layer or inside thereof. The transistor and the first electrode may be electrically connected via contact holes which are not illustrated.

The insulating layer 3 is also called a bank, or a pixel separation film. The insulating layer 3 covers the end of the first electrode, and is disposed surrounding the first electrode. The area where no insulating layer is disposed is in contact with the organic compound layer 4, and serves as a light emitting region.

The organic compound layer 4 includes a hole injection layer 41, a hole transport layer 42, a first light emitting layer 43, a second light emitting layer 44, and an electron transport layer 45.

The second electrode 5 has a material with a high light reflectance regardless of whether the second electrode 5 is a transparent electrode, a reflective electrode, or a semi-transparent electrode, and is disposed in common for a plurality of light emitting devices.

The protective layer 6 reduces permeation of moisture into the organic compound layer. The protective layer is illustrated like a single layer, but may have multiple layers. For each layer, an inorganic compound layer, and an organic compound layer may be provided.

The color filter 7 is divided into 7R, 7G, 7B according to its color. The color filter may be formed on a planarizing film which is not illustrated. In addition, a resin protective layer (not illustrated) may be provided on the color filter. The color filter may be formed on the protective layer 6. Alternatively, the color filter may be provided on an opposite substrate such as a glass substrate, then bonded together with a relevant substrate.

According to an aspect of the present disclosure, it is possible to provide an OLED chip with a reduced ratio of stray light to normal light from an organic light emitting device without impairing the emission characteristics of the organic light emitting device, and a method of manufacturing the OLED chip.

While the present disclosure has been described with reference to example embodiments, it is to be understood that the invention is not limited to the disclosed example embodiments. The scope of the following claims encompasses all such modifications and equivalent structures and functions.

**Claims**

1. An OLED chip comprising:

   a light emitting region (60) where a plurality of light emitting devices (69) is two-dimensionally arranged on a surface of a substrate (61); and
   a contact region (64a) disposed outside the light emitting region (60),
   wherein each of the plurality of light emitting devices (69) includes a first electrode (63), an organic layer (66), and a second electrode (67) on a light emitting side,
   the second electrode (67) is a common electrode of the plurality of light emitting devices (69),
   in plan view to the surface, the light emitting region (60) has a long side extending in a first direction (X) and a short side extending in a second direction (Y') intersecting the first direction (X), and
   in the plan view, an end of the second electrode (67) in the first direction (X) has a portion non-parallel to a third direction (Y) perpendicular to the first direction (X).

2. The OLED chip according to Claim 1, wherein in the plan view, a length of the long side of the light emitting region (60) is greater than or equal to five times a length of the short side.

3. The OLED chip according to Claim 1 or 2, wherein in the plan view, the end of the second electrode (67) has a curve.

4. The OLED chip according to any one of Claims 1 to 3, wherein in the plan view, a length in the third direction (Y) of the portion non-parallel to the third direction (Y) is longer than 1/3 a distance from an end of the second electrode (67) in the third direction (Y) to a portion at which the second electrode (67) is in contact with wiring (64).

5. The OLED chip according to any one of Claims 1 to 4, wherein a color filter is disposed on the contact region (64a), the color filter includes the contact region (64a) in the plan view, and an opening is provided at a position overlapping the light emitting region (60).

6. The OLED chip according to any one of Claims 1 to 4, further comprising:

   a first color filter overlapping the contact region (64a) in the plan view; and
   a second color filter overlapping the light emitting region (60) in the plan view,
   wherein a color of light transmitted through the second color filter is different from a color of light transmitted through the first color filter.

7. The OLED chip according to Claim 6, wherein the first color filter has a lower transmittance than the second color filter for light from the plurality of light emitting devices (69).

8. The OLED chip according to any one of Claims 1 to 7, wherein the substrate (61) is a silicon substrate.

9. The OLED chip according to any one of Claims 1 to 8, wherein the substrate (61) has a thickness of 200 μm to 700 μm.

10. The OLED chip according to any one of Claims 1 to 8, wherein the substrate (61) has a thickness of 200 μm to 408 μm.

11. The OLED chip according to any one of Claims 1 to 8, wherein the substrate (61) has a thickness of 378 μm to 408 μm.

12. An exposure head comprising:

    a plurality of OLED chips (53) disposed on a head substrate (50),
    wherein each of the plurality of OLED chips (53) has a side parallel to a longitudinal direction and a side parallel to a transverse direction, and
    at least one of the plurality of OLED chips (53) is the OLED chip (53) according to any one of Claims 1 to 11.

13. The exposure head according to Claim 12, wherein of the plurality of OLED chips (53), two adjacent OLED chips (53) in the longitudinal direction are disposed with a deviation in the transverse direction.

14. An exposure head comprising:

    a housing (54) that is arranged to hold a head substrate (50), and a lens array (52) disposed at a position opposed to the head substrate (50),
    wherein a plurality of OLED chips is disposed on the head substrate (50),
    each of the plurality of OLED chips (53) has a side parallel to a longitudinal direction and a side parallel to a transverse direction, and at least one of the plurality of OLED chips (53) is the OLED chip (53) according to any one of Claims 1 to 11.

15. The exposure head according to Claim 14, wherein the plurality of OLED chips (53) is disposed so that the second electrode (67) is opposed to the lens array (52).

16. An image forming apparatus comprising:

   a photoconductor drum (2);
   an exposure head (4) that is disposed to be opposed to the photoconductor drum (2) and is arranged to expose the photoconductor drum (2) to form a latent image on the photoconductor drum (2); and
   a developing unit (24) that is arranged to develop, with toner, the latent image formed on the photoconductor drum (2),
   wherein the exposure head (4) is the exposure head (4) according to any one of Claims 12 to 15.

17. A method of manufacturing an OLED chip, the method comprising:

   arranging a vapor deposition mask (111) having a plurality of openings to be opposed to a substrate (61) in which a first electrode (63) and an organic layer (66) are disposed;
   positioning the substrate (61) with respect to the vapor deposition mask (111); and
   forming a second electrode (67) by depositing a vapor deposition material (300) on the substrate (61) through the openings of the vapor deposition mask (111),
   wherein the openings of the vapor deposition mask (111) have a long side extending in a first direction (X), a short side extending in a second direction (Y') intersecting the first direction (X), and a portion at an end in the first direction (X), the portion being non-parallel to a third direction (Y) perpendicular to the first direction (X).

18. The method of manufacturing an OLED chip according to Claim 17, wherein in plan view to a surface of the substrate (61), a length of a long side of a light emitting region (60) of an OLED chip (53) to be manufactured is greater than or equal to five times a length of a short side of the light emitting region (60).

19. The method of manufacturing an OLED chip according to Claim 17 or 18, wherein in plan view to a surface of the substrate (61), an end of the second electrode (67) has a curve.

20. The method of manufacturing an OLED chip according to any one of Claims 17 to 19, wherein in plan view to a surface of the substrate (61), a length in the third direction (Y) of the portion non-parallel to the third direction (Y) is longer than 1/3 a distance from an end of the second electrode (67) in the third direction (Y) to a portion at which the second electrode (67) is in contact with wiring (64).

FIG. 1A

72  IC  67  60  71  116  69

Y
Y'
X
IB

IE

64a  IE  70  53  61  64a

FIG. 1B

91  92  92  91

90
68
67
61

66  69  69  66

64a  64  65  63  62  62  63  65  64  64a

60

FIG. 1C

C1
Y
X
C2

FIG. 1E

67 66 63 110

106  116
114  105
109
113  104
108  103
112
107  102
111  101
115  100

117

FIG. 1D

C1  C3
C2  C4

22

# FIG. 2

# FIG. 3A

# FIG. 3B

## FIG. 4A

## FIG. 4B

FIG. 5A

VB

VB

70

53

91

FIG. 5B

68   69   90   66   91

62  61  63  67        65        64        64a

FIG. 6A

FIG. 6B

FIG. 7

TRANSVERSE
DIRECTION

FIG. 8A

FIG. 8B

FIG. 8C

FIG. 8D

FIG. 8E

FIG. 9A

FIG. 9B

FIG. 9C

# FIG. 10

# FIG. 11

# FIG. 12

Europäisches
Patentamt

European
Patent Office

Office européen
des brevets

# EUROPEAN SEARCH REPORT

Application Number

EP 24 19 7362

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/364716 A1 (SHIOBARA SATORU [JP] ET AL) 17 December 2015 (2015-12-17) | 1-3,12, 17-19 | INV. H10K59/131 |
| Y | * paragraphs [0034], [0102], [0184]; figures 1, 2A, 2B, 8, 9A- 9C * <br> * figure 10 * | 12-16 | B41J2/45 G03G15/04 H10K59/80 H10K59/82 |
| X | US 2006/220532 A1 (TANABE SEIICHI [JP] ET AL) 5 October 2006 (2006-10-05) | 1,2,5-7, 12,14,15 | H10K59/90 |
| Y | * figures 6A-6C * <br> * paragraphs [0067], [0073], [0129], [0137] * <br> * paragraph [0075]; figures 2,4 * | 12-16 | ADD. H10K71/00 |
| X | US 2008/191603 A1 (SEIKO EPSON CORP [JP]) 14 August 2008 (2008-08-14) | 1,3,4 | |
| Y | * paragraphs [0040], [0041]; figures 1A, 4 * | 12-16 | |
| X | US 2014/197394 A1 (OTSUKA MANABU [JP] ET AL) 17 July 2014 (2014-07-17) | 1-4, 8-11, 17-20 | |
| Y | * paragraphs [0029], [0030], [0054], [0066], [0067]; figures 1A, 1B * | 12-16 | TECHNICAL FIELDS SEARCHED (IPC) |
| Y | US 2010/039489 A1 (NOMURA YUJIRO [JP] ET AL) 18 February 2010 (2010-02-18) * paragraphs [0073] - [0075], [0089]; figures 1,2,4,6,8,17 * | 12-20 | H10K B41J G03G |
| Y | US 2008/018236 A1 (ARAI TAKESHI [JP] ET AL) 24 January 2008 (2008-01-24) * figure 4 * | 17-20 | |
| Y | US 2005/166842 A1 (SAKAMOTO YOSHIAKI [JP]) 4 August 2005 (2005-08-04) * paragraph [74/75]; figure 7 * | 17-20 | |

The present search report has been drawn up for all claims

| Place of search | Date of completion of the search | Examiner |
|---|---|---|
| Munich | 23 January 2025 | Pusch, Catharina |

EPO FORM 1503 03.82 (P04C01)

**EP 4 518 630 A1**

## ANNEX TO THE EUROPEAN SEARCH REPORT
## ON EUROPEAN PATENT APPLICATION NO.

EP 24 19 7362

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2025

| Patent document cited in search report | Publication date | Patent family member(s) | Publication date |
|---|---|---|---|
| US 2015364716 A1 | 17-12-2015 | CN 105321980 A | 10-02-2016 |
| | | JP 6594013 B2 | 23-10-2019 |
| | | JP 2016021380 A | 04-02-2016 |
| | | TW 201601364 A | 01-01-2016 |
| | | US 2015364716 A1 | 17-12-2015 |
| US 2006220532 A1 | 05-10-2006 | EP 1708294 A2 | 04-10-2006 |
| | | JP 4539518 B2 | 08-09-2010 |
| | | JP 2006310257 A | 09-11-2006 |
| | | KR 20060106701 A | 12-10-2006 |
| | | TW I342720 B | 21-05-2011 |
| | | US 2006220532 A1 | 05-10-2006 |
| US 2008191603 A1 | 14-08-2008 | NONE | |
| US 2014197394 A1 | 17-07-2014 | JP 2014150057 A | 21-08-2014 |
| | | US 2014197394 A1 | 17-07-2014 |
| US 2010039489 A1 | 18-02-2010 | EP 1887441 A2 | 13-02-2008 |
| | | US 2008030566 A1 | 07-02-2008 |
| | | US 2010039489 A1 | 18-02-2010 |
| US 2008018236 A1 | 24-01-2008 | CN 101015234 A | 08-08-2007 |
| | | EP 1802177 A1 | 27-06-2007 |
| | | US 2008018236 A1 | 24-01-2008 |
| | | WO 2006027830 A1 | 16-03-2006 |
| US 2005166842 A1 | 04-08-2005 | CN 1652650 A | 10-08-2005 |
| | | JP 4441282 B2 | 31-03-2010 |
| | | JP 2005216814 A | 11-08-2005 |
| | | KR 20050078637 A | 05-08-2005 |
| | | TW I255666 B | 21-05-2006 |
| | | US 2005166842 A1 | 04-08-2005 |

EPO FORM P0459

For more details about this annex : see Official Journal of the European Patent Office, No. 12/82

35

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006236727 A